# EUROPEAN PATENT APPLICATION

(11) **EP 4 693 407 A1**
(43) Date of publication of application: **11.02.2026**
(21) Application number: 23933430.3
(22) Date of filing: 19.04.2023
(51) Int. Cl.: H01L 29/423

(54) **SEMICONDUCTOR DEVICE AND MANUFACTURING METHOD THEREFOR, AND POWER CONVERSION CIRCUIT AND VEHICLE**

(71) Applicant: Huawei Technologies Co., Ltd., Shenzhen, Guangdong 518129 (CN)
(72) Inventor: HAMADA, Kimimori, Shenzhen, Guangdong 518129 (CN); HU, Fei, Shenzhen, Guangdong 518129 (CN)
(74) Representative: Pfenning, Meinig & Partner mbB
(86) International application number: PCT/CN2023/089339
(87) International publication number: WO 2024/216553

(57) **Abstract**

This application provides a semiconductor device and a manufacturing method thereof, a power conversion circuit, and a vehicle. The semiconductor device includes an N-type semiconductor substrate, an epitaxial layer, and a first gate and a second gate that are connected to each other. The first gate extends in a first direction, and the second gate extends in a second direction. The first gate and the second gate are respectively located in different grooves in the epitaxial layer. A first gate dielectric is filled between the first gate and the groove, and the first gate is isolated from the groove through the first gate dielectric. A second gate dielectric is filled between the second gate and the groove, and the second gate is isolated from the groove through the second gate dielectric. In a direction perpendicular to a plane on which the semiconductor substrate is located, a thickness of the first gate dielectric is greater than a thickness of the second gate dielectric. Embodiments of this application can alleviate a conflict between an on-resistance and a capacitance, thereby improving performance of the semiconductor device.

## Description

### TECHNICAL FIELD

This application relates to the field of semiconductor technologies, and in particular, to a semiconductor device and a manufacturing method thereof, a power conversion circuit, and a vehicle.

### BACKGROUND

Compared with a silicon (Si) material, a silicon carbide (SiC) material has advantages such as a wide bandgap, a high critical breakdown electric field, high thermal conductivity, and a high saturated electron drift velocity. Compared with an insulated gate bipolar transistor (insulated gate bipolar transistor, IGBT) device made of the Si material, a metal-oxide semiconductor field-effect transistor (metal-oxide-semiconductor field-effect transistor, MOSFET) device made of the SiC material has characteristics such as a high breakdown voltage and a low conduction voltage drop. In addition, due to a unipolar conduction characteristic of the SiC material, the SiC MOSFET device has a faster switching speed, a lower conduction loss, and a lower switching loss than the Si IGBT device. Therefore, the SiC MOSFET device has replaced the Si IGBT device in some application scenarios such as an on-board micro controller unit (micro controller unit, MCU) and an on-board battery charger (on-board battery charger, OBC).

Compared with a device with a planar gate structure, in a SiC MOSFET device with a trench gate structure, a gate is embedded into a SiC body, so that a conductive channel of the device shifts from a planar direction to a vertical direction. This significantly reduces a cell size of the device, and greatly increases conductive channel density of the device, thereby significantly reducing an on-resistance of a chip, and improving a through-current capability. Therefore, the trench gate structure has become a mainstream technology direction of a device in the future.

However, there is a conflict between an on-resistance (related to an on-state loss) and a capacitance (related to a switching loss) of the SiC MOSFET device with the trench gate structure. Reducing a trench gate spacing can reduce the cell size and increase the channel density, thereby reducing the on-resistance and the on-state loss of the device. However, the capacitance, especially a Miller capacitance of the device (a capacitance between the gate and a drain) is significantly increased. As a result, a switching speed of the device becomes slow, and the switching loss is increased. Therefore, due to the conflict between the on-resistance and the capacitance of the device, it is difficult to further improve performance of the SiC MOSFET device.

### SUMMARY

This application provides a semiconductor device and a manufacturing method thereof, a power conversion circuit, and a vehicle, to alleviate a conflict between an on-resistance and a capacitance of the semiconductor device, thereby improving performance of the semiconductor device.

According to a first aspect, an embodiment of this application provides a semiconductor device. The semiconductor device provided in this embodiment of this application may include an N-type semiconductor substrate, an epitaxial layer disposed on the semiconductor substrate, and a first gate and a second gate that are connected to each other. The first gate extends in a first direction, the second gate extends in a second direction, and the first direction and the second direction are two directions that are parallel to a plane on which the semiconductor substrate is located and that intersect with each other. The first gate and the second gate are respectively located in different grooves in the epitaxial layer. A first gate dielectric is filled between the first gate and the groove, and the first gate is isolated from the groove through the first gate dielectric. A second gate dielectric is filled between the second gate and the groove, and the second gate is isolated from the groove through the second gate dielectric. In a direction perpendicular to the plane on which the semiconductor substrate is located, a thickness of the first gate dielectric is greater than a thickness of the second gate dielectric.

The semiconductor device in this embodiment of this application may be a SiC MOSFET device, and each of the semiconductor substrate and the epitaxial layer may include a silicon carbide (SiC) material. The semiconductor substrate may be a monocrystalline silicon carbide substrate doped with a pentavalent element. The epitaxial layer may include a SiC material doped with a corresponding impurity, and the epitaxial layer may be manufactured by using an epitaxial growth process.

The semiconductor device in this embodiment of this application is a SiC MOSFET device with a trench gate structure. A plurality of grooves are disposed in the epitaxial layer, and a gate is disposed in the groove. The gate may be embedded inside the epitaxial layer, so that a conductive channel direction of the semiconductor device is a vertical direction. This increases conductive channel density of the semiconductor device, thereby reducing an on-resistance. In addition, the semiconductor device in this embodiment of this application includes the first gate and the second gate that are connected to each other. The first gate extends in the first direction, and the second gate extends in the second direction. This can further increase the conductive channel density, thereby further reducing the on-resistance. In addition, in this embodiment of this application, in the direction perpendicular to the plane on which the semiconductor substrate is located, the thickness of the first gate dielectric is greater than the thickness of the second gate dielectric. The thicker first gate dielectric is disposed, so that a capacitance of the semiconductor device can be reduced. This can alleviate a conflict between an on-resistance and a capacitance, thereby improving performance of the semiconductor device.

In a possible implementation, a plurality of first grooves and a plurality of second grooves are disposed in the epitaxial layer; the first grooves extend in the first direction and are arranged in the second direction; the second grooves extend in the second direction and are arranged in the first direction; and the first grooves intersect with the second grooves. The first grooves and the second grooves extend to the inside of the epitaxial layer in a third direction from a surface of a side that is of the epitaxial layer and that is away from the semiconductor substrate. The third direction is the direction perpendicular to the plane on which the semiconductor substrate is located. Optionally, the first direction, the second direction, and the third direction may be perpendicular to each other. The first gate is located in the first groove, and the second gate is located in the second groove. For example, one first gate may be disposed in each first groove, and one second gate may be disposed in each second groove. The first gate dielectric is filled between the first gate and the first groove, and the first gate is isolated from the first groove through the first gate dielectric. The second gate dielectric is filled between the second gate and the second groove, and the second gate is isolated from the second groove through the second gate dielectric. The thickness of the first gate dielectric in the third direction is greater than the thickness of the second gate dielectric in the third direction.

In other words, the first gate is filled into the first groove separated by the first gate dielectric, and the second gate is filled into the second groove separated by the second gate dielectric, so that the first gate and the second gate are embedded inside the epitaxial layer. Therefore, the semiconductor device in this embodiment of this application is a SiC MOSFET device with a groove structure.

In a possible implementation, the first gate and the second gate may be made of a polycrystalline silicon material, or the first gate and the second gate may be made of a metal material like tungsten (W), aluminum (Al), titanium (Ti), copper (Cu), molybdenum (Mo), or platinum (Pt). Certainly, the first gate and the second gate may alternatively be made of another material with good conductivity. This is not limited herein.

In this embodiment of this application, the semiconductor device may further include an interlayer dielectric layer, a source, and a drain. The interlayer dielectric layer covers a surface of a side that is of the first gate and the second gate and that is away from the semiconductor substrate, a plurality of contact holes are disposed in the interlayer dielectric layer, and orthographic projections of the contact holes on the semiconductor substrate do not overlap orthographic projections of the first gate and the second gate on the semiconductor substrate. The source is disposed on a side that is of the interlayer dielectric layer and that is away from the semiconductor substrate, and the source is in contact with the epitaxial layer through the contact holes. The drain is located on a side that is of the semiconductor substrate and that is away from the epitaxial layer. The plurality of contact holes in the interlayer dielectric layer may expose some regions of the epitaxial layer, so that the source can be in contact with the epitaxial layer through the contact holes. The orthographic projections of the contact holes on the semiconductor substrate do not overlap the orthographic projections of the first gate and the second gate on the semiconductor substrate. This can prevent the source from being in contact with the first gate and the second gate.

In a possible implementation, the interlayer dielectric layer may include a dielectric material. The dielectric material may include but is not limited to silicon dioxide (SiO2), silicon oxynitride (SiNO), silicon oxycarbide (SiCO), and silicon nitride (SiNx). The source and the drain may be made of a metal material. For example, the metal material may include but is not limited to W, Al, Ti, Cu, Mo, or Pt.

In a possible implementation, a depth of each first groove may be greater than a depth of each second groove. A thickness of each first gate in the third direction may be consistent with a thickness of each second gate in the third direction. Therefore, the thickness of the first gate dielectric in the third direction is greater than the thickness of the second gate dielectric in the third direction. A part that is of the first gate dielectric and that exceeds the second gate dielectric in thickness may be disposed at the bottom of the first groove, to facilitate manufacturing.

That the thicknesses of the first gate and the second gate in the third direction are consistent means that the first gate and the second gate are equal within a process error range. In a manufacturing procedure, the first gate and the second gate may be manufactured by using a same process. In this way, process steps can be reduced, and process costs can be reduced. Certainly, in some cases, when the first gate and the second gate are manufactured by using different processes, the thicknesses of the first gate and the second gate in the third direction may alternatively be unequal, provided that the thickness of the first gate dielectric in the third direction is greater than the thickness of the second gate dielectric in the third direction.

During specific implementation, the depths of the first grooves may be equal within a process error range. In this way, in a manufacturing procedure, the first grooves may be manufactured by using a same process. Similarly, the depths of the second grooves may be equal within a process error range. In this way, the second grooves may be manufactured by using a same process. In this way, process steps can be reduced, and process costs can be reduced.

A spacing between two adjacent second grooves in the first direction is a first spacing, and a spacing between two adjacent first grooves in the second direction is a second spacing. During specific setting, specific sizes of the first spacing and the second spacing may be set based on an actual requirement. The first spacing may be greater than the second spacing, or the first spacing may be equal to the second spacing, or the first spacing may be less than the second spacing. In some embodiments of this application, the first grooves may be evenly spaced, or may be unevenly spaced; and the second grooves may be evenly spaced, or may be unevenly spaced.

In this embodiment of this application, the epitaxial layer may include an N-type semiconductor region and a first P-type semiconductor region. The N-type semiconductor region may be doped with an N-type impurity like nitrogen (N), phosphorus (P), or arsenic (As), and the first P-type semiconductor region may be doped with a P-type impurity like boron (B), aluminum (Al), or gallium (Ga).

The first P-type semiconductor region is located on a side that is of the N-type semiconductor region and that is away from the semiconductor substrate. Each first groove and each second groove penetrate the first P-type semiconductor region in the third direction, and extend into the N-type semiconductor region. In this way, the first gate and the second gate can form the SiC MOSFET device with the trench gate structure together with the first P-type semiconductor region through the gate dielectric (the first gate dielectric or the second gate dielectric).

In some embodiments of this application, the epitaxial layer may further include a plurality of P-type connection regions and a source region that are disposed on a same layer. Each P-type connection region corresponds to a location of one contact hole, an orthographic projection of the P-type connection region on the semiconductor substrate falls within a range of an orthographic projection of the corresponding contact hole on the semiconductor substrate, and the P-type connection region connects the first P-type semiconductor region to the source. Doping concentration of the P-type connection region may be greater than doping concentration of the first P-type semiconductor region, so that the P-type connection region has good conductivity. The source region is a region other than the plurality of first grooves, the plurality of second grooves, and the plurality of P-type connection regions on the layer on which the source region is located. For example, a part of the source region may be covered by the interlayer dielectric layer, and another part may be electrically connected to the source.

During specific implementation, an N-type impurity like nitrogen (N), phosphorus (P), or arsenic (As) may be injected, by using an ion injection process, into a region in which the source region is to be formed, to form the source region; and a P-type impurity like boron (B), aluminum (Al), or gallium (Ga) is injected, by using the ion injection process, into a region in which the P-type connection region is to be formed, to form the P-type connection region.

The first groove (or the second groove) has the first P-type semiconductor region on both sides in the second direction (or the first direction). When the semiconductor device operates, under control of the first gate (or the second gate), the first P-type semiconductor region may form an N-type inversion channel, so that the source is connected to the drain through a conduction path of the source region, the first P-type semiconductor region, the N-type semiconductor region, and the semiconductor substrate.

During specific implementation, doping concentration of the semiconductor substrate is large. For example, the doping concentration of the semiconductor substrate may be greater than doping concentration of the N-type semiconductor region, so that the semiconductor substrate has good conductivity. In this way, the semiconductor substrate may be used as a drain region of the semiconductor device. Doping concentration of the source region is also large. For example, the doping concentration of the source region may be greater than the doping concentration of the N-type semiconductor region, so that the source region has good conductivity. In this way, when the semiconductor device operates, it is convenient to connect the source to the drain. This reduces the on-resistance of the semiconductor device.

The semiconductor device in this embodiment of this application is the SiC MOSFET device with the trench gate structure. At the bottom and corners of the first groove and the second groove, the gate dielectric (the first gate dielectric or the second gate dielectric) bears high electric field strength when the semiconductor device operates, and is a weak point of electric field breakdown, easily resulting in a failure of long-term operating reliability of the semiconductor device. To effectively shield the gate dielectric from a high electric field stress, the epitaxial layer in this embodiment of this application may further include a second P-type semiconductor region. The second P-type semiconductor region is located on a side that is of the first groove and that is close to the semiconductor substrate. The second P-type semiconductor region is electrically connected to the source. When the semiconductor device operates, a voltage is loaded to the source. Because the second P-type semiconductor region is electrically connected to the source, the voltage loaded to the source is input to the second P-type semiconductor region, so that the second P-type semiconductor region also has the corresponding voltage. This can effectively shield an electric field of the gate dielectric at the bottom of the first groove and an electric field of the gate dielectric at the bottom of the second groove, thereby improving operating robustness of the semiconductor device.

For example, a thickness of the second P-type semiconductor region in the third direction may be less than 1 µm. For example, the thickness of the second P-type semiconductor region in the third direction may be 0.3 µm to 0.8 µm. Certainly, a thickness of the second P-type semiconductor region in the third direction z may alternatively be greater than 1 µm. This is not limited herein. Optionally, the second P-type semiconductor region may be doped with a P-type impurity like boron (B), aluminum (Al), or gallium (Ga). To make the second P-type semiconductor region have good conductivity, doping concentration of the second P-type semiconductor region may be set to be large. For example, the doping concentration of the second P-type semiconductor region may be greater than the doping concentration of the first P-type semiconductor region.

In some application scenarios, the source of the semiconductor device may be grounded, and the drain may be electrically connected to another element. Because the second P-type semiconductor region is electrically connected to the source, a voltage of the second P-type semiconductor region is also a ground voltage (0 V). This can effectively shield an electric field of the gate dielectric at the bottom of the first groove and an electric field of the gate dielectric at the bottom of the second groove, thereby improving operating robustness of the semiconductor device. In some other application scenarios, the source of the semiconductor device may be electrically connected to another element, and the drain is also electrically connected to the another element. In this case, a voltage of the source is a voltage (which may not be 0) of an input signal of the another element. Because the second P-type semiconductor region is electrically connected to the source, a voltage of the second P-type semiconductor region is also the voltage of the input signal. This can effectively shield an electric field of the gate dielectric at the bottom of the first groove and an electric field of the gate dielectric at the bottom of the second groove, thereby improving operating robustness of the semiconductor device.

In a possible implementation, the N-type semiconductor region may include a first N-type semiconductor region and a second N-type semiconductor region. The second N-type semiconductor region is located between the first N-type semiconductor region and the first P-type semiconductor region, and doping concentration of the second N-type semiconductor region is greater than doping concentration of the first N-type semiconductor region. Each first groove and each second groove penetrate the second N-type semiconductor region in the third direction, and extend into the first N-type semiconductor region. The second P-type semiconductor region may be located in the first N-type semiconductor region. Each of the first N-type semiconductor region and the second N-type semiconductor region may include an N-type impurity like nitrogen (N), phosphorus (P), or arsenic (As). The doping concentration of the first N-type semiconductor region is small, so that voltage withstand performance of the semiconductor device can be improved. The doping concentration of the second N-type semiconductor region is large, so that the on-resistance of the semiconductor device can be reduced.

In another possible implementation, the N-type semiconductor region may include a first N-type semiconductor region, a second N-type semiconductor region, and a third N-type semiconductor region. The second N-type semiconductor region is located on a side that is of the first N-type semiconductor region and that is away from the semiconductor substrate, and the third N-type semiconductor region is located between the first N-type semiconductor region and the second N-type semiconductor region. Doping concentration of the second N-type semiconductor region is greater than doping concentration of the first N-type semiconductor region, and doping concentration of the third N-type semiconductor region is greater than the doping concentration of the first N-type semiconductor region. Each first groove and each second groove penetrate the second N-type semiconductor region in the third direction, and extend into the third N-type semiconductor region. The second P-type semiconductor region is located in the third N-type semiconductor region. Each of the first N-type semiconductor region, the second N-type semiconductor region, and the third N-type semiconductor region may include an N-type impurity like nitrogen (N), phosphorus (P), or arsenic (As). The doping concentration of the first N-type semiconductor region is small, so that voltage withstand performance of the semiconductor device can be improved. The doping concentration of the second N-type semiconductor region is large, so that the on-resistance of the semiconductor device can be reduced. In addition, the doping concentration of the third N-type semiconductor region is large, so that the on-resistance of the semiconductor device can be further reduced.

In some other embodiments of this application, the epitaxial layer may further include a third P-type semiconductor region. The third P-type semiconductor region is located on a side that is of the second groove and that is close to the semiconductor substrate, and the third P-type semiconductor region is electrically connected to the source. In other words, both the second P-type semiconductor region at the bottom of the first groove and the third P-type semiconductor region at the bottom of the second groove are electrically connected to the source. In this way, when the semiconductor device operates, a voltage is loaded to the source. Because both the second P-type semiconductor region and the third P-type semiconductor region are electrically connected to the source, the voltage loaded to the source is input to the second P-type semiconductor region and the third P-type semiconductor region, so that the second P-type semiconductor region and the third P-type semiconductor region also have the corresponding voltage. This can effectively shield an electric field of the gate dielectric at the bottom of the first groove and an electric field of the gate dielectric at the bottom of the second groove, thereby improving operating robustness of the semiconductor device.

Optionally, the third P-type semiconductor region may be doped with a P-type impurity like boron (B), aluminum (Al), or gallium (Ga). To make the third P-type semiconductor region have good conductivity, doping concentration of the third P-type semiconductor region may be set to be large. For example, the doping concentration of the third P-type semiconductor region may be greater than the doping concentration of the first P-type semiconductor region.

In some application scenarios, the source of the semiconductor device may be grounded, and the drain may be electrically connected to another element. Because the second P-type semiconductor region and the third P-type semiconductor region are electrically connected to the source, a voltage of the second P-type semiconductor region and a voltage of the third P-type semiconductor region are also a ground voltage (0 V). This can effectively shield an electric field of the gate dielectric at the bottom of the first groove and an electric field of the gate dielectric at the bottom of the second groove, thereby improving operating robustness of the semiconductor device. In some other application scenarios, the source of the semiconductor device may be electrically connected to another element, and the drain is also electrically connected to the another element. In this case, a voltage of the source is a voltage (which may not be 0) of an input signal of the another element. Because the second P-type semiconductor region and the third P-type semiconductor region are electrically connected to the source, a voltage of the second P-type semiconductor region and a voltage of the third P-type semiconductor region are also the voltage of the input signal. This can effectively shield an electric field of the gate dielectric at the bottom of the first groove and an electric field of the gate dielectric at the bottom of the second groove, thereby improving operating robustness of the semiconductor device.

In a possible implementation, a thickness of the third P-type semiconductor region in the third direction may be less than 1 µm, and the thicknesses of the second P-type semiconductor region and the third P-type semiconductor region in the third direction may be approximately equal within a process error range, so that the second P-type semiconductor region and the third P-type semiconductor region may be manufactured together by using a same manufacturing process. This can reduce process steps, and reduce manufacturing costs. In another possible implementation, a thickness of the third P-type semiconductor region in the third direction z may alternatively be greater than 1 µm, and the thickness of the third P-type semiconductor region in the third direction z may be greater than the thickness of the second P-type semiconductor region in the third direction. In a manufacturing procedure, the second P-type semiconductor region and the third P-type semiconductor region may be separately manufactured by using different process steps.

In a possible implementation, the N-type semiconductor region may include a first N-type semiconductor region and a second N-type semiconductor region. The second N-type semiconductor region is located between the first N-type semiconductor region and the first P-type semiconductor region, and doping concentration of the second N-type semiconductor region is greater than doping concentration of the first N-type semiconductor region. Each first groove and each second groove penetrate the second N-type semiconductor region in the third direction, and extend into the first N-type semiconductor region. The second P-type semiconductor region and the third P-type semiconductor region are located in the first N-type semiconductor region. Each of the first N-type semiconductor region and the second N-type semiconductor region may include an N-type impurity like nitrogen (N), phosphorus (P), or arsenic (As). The doping concentration of the first N-type semiconductor region is small, so that voltage withstand performance of the semiconductor device can be improved. The doping concentration of the second N-type semiconductor region is large, so that the on-resistance of the semiconductor device can be reduced.

In some cases, a thickness of the third P-type semiconductor region in the third direction may be small. For example, thicknesses of the second P-type semiconductor region and the third P-type semiconductor region in the third direction may be approximately equal within a process error range. In some other cases, a thickness of the third P-type semiconductor region in the third direction may be large. For example, the thickness of the third P-type semiconductor region in the third direction may be greater than the thickness of the second P-type semiconductor region in the third direction.

In another possible implementation, the N-type semiconductor region includes a first N-type semiconductor region, a second N-type semiconductor region, and a third N-type semiconductor region. The second N-type semiconductor region is located on a side that is of the first N-type semiconductor region and that is away from the semiconductor substrate, and the third N-type semiconductor region is located between the first N-type semiconductor region and the third N-type semiconductor region. Doping concentration of the second N-type semiconductor region is greater than doping concentration of the first N-type semiconductor region, and doping concentration of the third N-type semiconductor region is greater than the doping concentration of the first N-type semiconductor region. Each first groove and each second groove penetrate the second N-type semiconductor region in the third direction, and extend into the third N-type semiconductor region. The second P-type semiconductor region and the third P-type semiconductor region are located in the third N-type semiconductor region.

Each of the first N-type semiconductor region, the second N-type semiconductor region, and the third N-type semiconductor region may include an N-type impurity like nitrogen (N), phosphorus (P), or arsenic (As). The doping concentration of the first N-type semiconductor region is small, so that voltage withstand performance of the semiconductor device can be improved. The doping concentration of the second N-type semiconductor region and the doping concentration of the third N-type semiconductor region are large, so that the on-resistance of the semiconductor device can be reduced.

According to a second aspect, an embodiment of this application further provides a manufacturing method of any one of the foregoing semiconductor devices. The manufacturing method of the semiconductor device provided in this embodiment of this application may include the following steps:
growing an epitaxial layer on an N-type semiconductor substrate;
etching the epitaxial layer to form a first groove and a second groove;
forming a first gate and a first gate dielectric in the first groove, and forming a second gate and a second gate dielectric in the second groove, where in a direction perpendicular to a plane on which the semiconductor substrate is located, a thickness of the first gate dielectric is greater than a thickness of the second gate dielectric;
forming an interlayer dielectric layer on the first gate and the second gate, and patterning the interlayer dielectric layer, to form a plurality of contact holes in the interlayer dielectric layer, where orthographic projections of the contact holes on the semiconductor substrate do not overlap orthographic projections of the first gate and the second gate on the semiconductor substrate; and
forming a source on the interlayer dielectric layer, and enabling the source to be in contact with the epitaxial layer through the contact holes; and forming a drain on a side that is of the semiconductor substrate and that is away from the epitaxial layer.

In a possible implementation, the growing the epitaxial layer on the N-type semiconductor substrate may specifically include the following steps:
forming an N-type semiconductor region on the semiconductor substrate by using an epitaxial process, and injecting ions into the N-type semiconductor region by using an ion injection process, to form a first P-type semiconductor region, where for example, the N-type semiconductor region may include an N-type impurity like nitrogen (N), phosphorus (P), or arsenic (As); a P-type impurity like boron (B), aluminum (Al), or gallium (Ga) may be injected into the epitaxial layer, to obtain the P-type semiconductor region; and during specific implementation, a first N-type semiconductor region may be formed by using an epitaxial process, and then, an N-type impurity is injected into a surface of the first N-type semiconductor region, to form a second N-type semiconductor region with large doping concentration on the surface of the first N-type semiconductor region; and
injecting ions into a surface of the epitaxial layer by using the ion injection process, to form a plurality of P-type connection regions and a source region that are disposed on a same layer, where each P-type connection region corresponds to a location of one to-be-formed contact hole, and an orthographic projection of the P-type connection region on the semiconductor substrate falls within a range of an orthographic projection of the corresponding contact hole on the semiconductor substrate; the source region is configured to be in contact with the subsequently formed source; generally, doping concentration of the source region is large, for example, the doping concentration of the source region may be greater than doping concentration of the N-type semiconductor region, so that the source region has good conductivity; the P-type connection region is configured to connect the first P-type semiconductor region to the subsequently formed source; doping concentration of the P-type connection region may be greater than doping concentration of the first P-type semiconductor region, so that the P-type connection region has good conductivity; and during specific implementation, an N-type impurity like nitrogen (N), phosphorus (P), or arsenic (As) may be injected, by using the ion injection process, into a region in which the source region is to be formed, to form the source region; and a P-type impurity like boron (B), aluminum (Al), or gallium (Ga) is injected, by using the ion injection process, into a region in which the P-type connection region is to be formed, to form the P-type connection region.

In some embodiments of this application, the etching the epitaxial layer to form the first groove and the second groove may specifically include the following steps:
etching the epitaxial layer to form a plurality of first grooves that extend in a first direction and that are arranged in a second direction, where for example, a mask consistent with a pattern of the first grooves may be formed on the epitaxial layer, a region in which the first grooves do not need to be formed may be covered by the mask, and a region in which the first grooves need to be formed is exposed; and then, the region that is of the epitaxial layer and that is not covered by the mask is etched by using an etching process, until the N-type semiconductor region of the epitaxial layer is etched, to obtain the plurality of first grooves;
injecting ions into a bottom of the first groove by using the ion injection process, to form a second P-type semiconductor region on a side that is of the first groove and that is close to the semiconductor substrate, where the second P-type semiconductor region may be electrically connected to the source; when the semiconductor device operates, a voltage is loaded to the source, and the voltage loaded to the source is input to the second P-type semiconductor region, so that the second P-type semiconductor region also has the corresponding voltage; this can effectively shield an electric field of a gate dielectric at the bottom of the groove, thereby improving operating robustness of the semiconductor device; during specific implementation, a P-type impurity like boron (B), aluminum (Al), or gallium (Ga) may be injected into the bottom of the first groove, to obtain the second P-type semiconductor region; to make the second P-type semiconductor region have good conductivity, doping concentration of the second P-type semiconductor region may be large, and for example, the doping concentration of the second P-type semiconductor region may be greater than the doping concentration of the first P-type semiconductor region; for example, a thickness of the second P-type semiconductor region in the third direction may be less than 1 µm, and for example, the thickness of the second P-type semiconductor region in the third direction may be 0.3 µm to 0.8 µm; certainly, a thickness of the second P-type semiconductor region in the third direction z may alternatively be greater than 1 µm; and this is not limited herein;
depositing a first dielectric layer that fills each first groove and that covers the surface of the epitaxial layer, and patterning the first dielectric layer, so that a pattern of the first dielectric layer is consistent with a pattern of a plurality of to-be-formed second grooves, where for example, a photoresist layer may be formed on a surface of the first dielectric layer, and the photoresist layer is photoetched by using a mask having the pattern of the plurality of to-be-formed second grooves as a shield, to transfer the pattern on the mask to the photoresist layer; and then, the first dielectric layer is etched by using the photoresist layer as a shield, to transfer the pattern of the plurality of second grooves to the first dielectric layer, where the first dielectric layer may cover a region in which the second grooves do not need to be formed, and expose a region in which the second grooves need to be formed;
etching the epitaxial layer by using the first dielectric layer as a mask, to form the plurality of second grooves that extend in the second direction and that are arranged in the first direction, where because the first dielectric layer may cover the region in which the second grooves do not need to be formed, and expose the region in which the second grooves need to be formed, the region that is of the epitaxial layer and that is not covered by the first dielectric layer is etched until the N-type semiconductor region of the epitaxial layer is etched, to obtain the plurality of second grooves; and in this embodiment of this application, a depth of each first groove may be greater than a depth of each second groove, so that the thickness of the subsequently formed first gate dielectric in the third direction can be greater than the thickness of the second gate dielectric in the third direction; and
removing the first dielectric layer.

In a possible implementation, the forming the first gate and the first gate dielectric in the first groove, and the forming the second gate and the second gate dielectric in the second groove may specifically include the following steps:
depositing a second dielectric layer that fills each first groove and each second groove and that covers the surface of the epitaxial layer, where the second dielectric layer is etched until a bottom surface of each second groove is exposed, and a part of the second dielectric layer is left at the bottom of each first groove, where the part of the second dielectric layer left at the bottom of the first groove may be used as a part of the first gate dielectric; and in this embodiment of this application, in a back-etching manner, the part of the first gate dielectric may be first formed at the bottom of the first groove, and in this way, the remaining first gate dielectric and the second gate dielectric may be subsequently manufactured by using a same process step, or the first gate and the second gate may be manufactured by using a same process step;
forming the first gate dielectric on a side wall of each first groove, and forming the second gate dielectric on a side wall of each second groove, where for example, the first gate dielectric (or the second gate dielectric) may be formed on the side wall of the first groove (or the second groove) by using a deposition process or an oxidation process; and
depositing a gate layer that fills each first groove and each second groove and that covers the surface of the epitaxial layer, where the gate layer may be made of a polycrystalline silicon material or a metal material; and then etching the gate layer until the surface of the epitaxial layer is exposed, to form the first gate in each first groove and form the second gate in each second groove, where the first gate and the second gate are manufactured in a back-etching manner, so that the grooves can be accurately filled with the gates, to avoid insufficient filling or excessive filling.

In some embodiments of this application, after the etching the epitaxial layer by using the first dielectric layer as the mask, to form the plurality of second grooves that extend in the second direction and that are arranged in the first direction, and before the removing the first dielectric layer, the method may further include the following step:
injecting ions into a bottom of the second groove by using the ion injection process, to form a third P-type semiconductor region on a side that is of the second groove and that is close to semiconductor substrate, where for example, a P-type impurity like boron (B), aluminum (Al), or gallium (Ga) may be injected into the bottom of the second groove, to form the third P-type semiconductor region; and during specific implementation, to make the third P-type semiconductor region have good conductivity, doping concentration of the third P-type semiconductor region may be set to be large, and for example, the doping concentration of the third P-type semiconductor region may be greater than the doping concentration of the first P-type semiconductor region.

In a possible implementation, a thickness of the third P-type semiconductor region in the third direction may be less than 1 µm, and the thicknesses of the second P-type semiconductor region and the third P-type semiconductor region in the third direction may be approximately equal within a process error range, so that the second P-type semiconductor region and the third P-type semiconductor region may be manufactured together by using a same manufacturing process. This can reduce process steps, and reduce manufacturing costs. In another possible implementation, a thickness of the third P-type semiconductor region in the third direction z may alternatively be greater than 1 µm, and the thickness of the third P-type semiconductor region in the third direction z may be greater than the thickness of the second P-type semiconductor region in the third direction. In a manufacturing procedure, the second P-type semiconductor region and the third P-type semiconductor region may be separately manufactured by using different process steps.

According to a third aspect, an embodiment of this application further provides a power conversion circuit. The power conversion circuit may be an alternating current-direct current conversion circuit and/or a direct current-direct current conversion circuit. The power conversion circuit may include a circuit board and one or more of the foregoing semiconductor devices, and the semiconductor device is connected to the circuit board. Because the foregoing semiconductor device has good performance, the power conversion circuit including the foregoing semiconductor device also has good performance.

A problem-resolving principle of the power conversion circuit is similar to a problem-resolving principle of the foregoing semiconductor device. Therefore, for technical effect of the power conversion circuit, refer to the technical effect of the foregoing semiconductor device. Repeated parts are not described again.

According to a fourth aspect, an embodiment of this application further provides a vehicle. The vehicle includes the foregoing power conversion circuit provided in embodiments of this application. The power conversion circuit is configured to convert an alternating current and/or a direct current and then output a direct current. Because the power conversion circuit has good performance, the vehicle including the power conversion circuit also has good circuit performance.

A problem-resolving principle of the vehicle is similar to the problem-resolving principle of the foregoing power conversion circuit. Therefore, for technical effect of the vehicle, refer to the technical effect of the foregoing power conversion circuit. Repeated parts are not described again.

### BRIEF DESCRIPTION OF DRAWINGS

FIG. 1 is a diagram of a structure of an electric vehicle according to an embodiment of this application;
FIG. 2 is a diagram of a structure of an electronic device according to an embodiment of this application;
FIG. 3 is a diagram of a structure of a semiconductor device according to an embodiment of this application;
FIG. 4 is a diagram of a cross section at a dashed line AA' in FIG. 3;
FIG. 5 is a top view of a structure of an epitaxial layer according to an embodiment of this application;
FIG. 6 is a top view of a structure of an interlayer dielectric layer according to an embodiment of this application;
FIG. 7 is a diagram of characteristic comparison between a semiconductor device in an embodiment of this application and a semiconductor device in the conventional technology;
FIG. 8 is a diagram of another structure of a semiconductor device according to an embodiment of this application;
FIG. 9 is a diagram of another structure of a semiconductor device according to an embodiment of this application;
FIG. 10 is a diagram of another structure of a semiconductor device according to an embodiment of this application;
FIG. 11 is a diagram of another structure of a semiconductor device according to an embodiment of this application;
FIG. 12 is a diagram of another structure of a semiconductor device according to an embodiment of this application;
FIG. 13 is a flowchart of a semiconductor device manufacturing method according to an embodiment of this application;
FIG. 14 to FIG. 24 are diagrams of structures corresponding to steps in a manufacturing method according to an embodiment of this application; and
FIG. 25 is a diagram of a structure corresponding to a step of manufacturing a third P-type semiconductor region.

### Reference numerals:

110: electric vehicle; 101: power conversion circuit; 1011: DC-DC converter; 102: storage battery; 103: load; 120: electronic device; 130: power supply; 10: semiconductor substrate; 20: epitaxial layer; 21: N-type semiconductor region; 211: first N-type semiconductor region; 212: second N-type semiconductor region; 213: third N-type semiconductor region; 22: first P-type semiconductor region; 23: source region; 24: P-type connection region; 25: second P-type semiconductor region; 26: third P-type semiconductor region; 31: first groove; 32: second groove; 301: first dielectric layer; 302: second dielectric layer; 41: first gate; 42: second gate; 51: first gate dielectric; 52: second gate dielectric; 60: interlayer dielectric layer; 61: contact hole; 70: source; 80: drain; x: first direction; y: second direction; and z: third direction.

### DESCRIPTION OF EMBODIMENTS

To make objectives, technical solutions, and advantages of this application clearer, the following further describes this application in detail with reference to accompanying drawings. It should be noted that same reference numerals in the accompanying drawings of this application denote same or similar structures. Therefore, repeated descriptions thereof are omitted. Expressions of locations and directions in this application are described by using the accompanying drawings as examples. However, changes may also be made as required, and all the changes fall within the protection scope of this application. The accompanying drawings in this application are merely used to illustrate relative location relationships and do not represent an actual scale.

In embodiments of this application, a specific operation method in a method embodiment may also be applied to an apparatus embodiment or a system embodiment. It should be noted that, in the descriptions of this application, "a plurality of" means two or more, that is, "a plurality of" may be understood as "at least two". Words such as "first" and "second" are merely used for distinguishing and description, but should not be understood as indicating or implying relative importance, or should not be understood as indicating or implying a sequence. In addition, it should be noted that, in embodiments of this application, a "connection" is an electrical connection, and a connection between two electrical elements may be a direct or indirect connection between the two electrical elements. For example, that A is connected to B may be that A is directly connected to B, or may be that A is indirectly connected to B through one or more other electrical elements. For example, that A is connected to B may alternatively be that A is directly connected to C, C is directly connected to B, and A and B are connected through C.

It should be noted that specific details are set forth in the following descriptions for ease of fully understanding this application. However, this application can be implemented in a plurality of manners different from those described herein, and persons skilled in the art can perform similar promotion without departing from the connotation of this application. Therefore, this application is not limited to the specific implementations disclosed below. The following descriptions of this specification are example implementations of this application. However, the descriptions are intended to describe the general principle of this application, and are not intended to limit the scope of this application.

For ease of understanding a semiconductor device and a manufacturing method thereof, a power conversion circuit, and a vehicle that are provided in embodiments of this application, the following first describes an application scenario of this application.

The semiconductor device provided in embodiments of this application may be used in a vehicle, for example, may be used in an electric vehicle. For example, the semiconductor device may be used in components such as an on-board micro controller unit (micro controller unit, MCU) and an on-board battery charger (on-board battery charger, OBC) in the vehicle. It should be noted that the semiconductor device provided in embodiments of this application is intended to include but is not limited to being used in these components and any other suitable type of components. The following uses an example in which the vehicle is an electric vehicle for description.

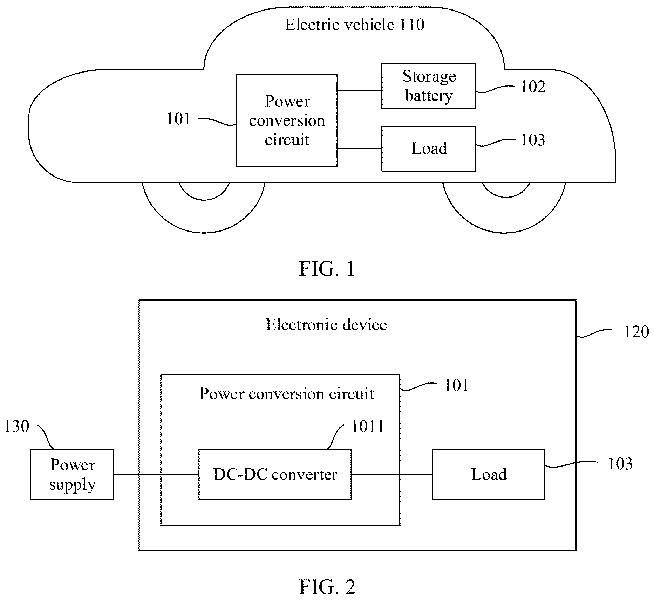

FIG. 1 is a diagram of a structure of an electric vehicle according to an embodiment of this application. As shown in FIG. 1, the electric vehicle 110 may include a power conversion circuit 101 and a storage battery 102.

In a possible implementation, the power conversion circuit 101 may include an alternating current (Alternating Current, AC)-direct current (Direct Current, DC) conversion circuit and a direct current-direct current (DC-DC) conversion circuit. The power conversion circuit 101 may also be referred to as an inverter. For example, when the electric vehicle 110 is charged, the electric vehicle 110 may be connected to a three-phase power grid, to receive a three-phase alternating current provided by the three-phase power grid. A power switching transistor of the AC-DC conversion circuit in the power conversion circuit 101 is controlled to operate, so that the AC-DC conversion circuit can convert the three-phase alternating current into a direct current; and a power switching transistor of the DC-DC conversion circuit in the power conversion circuit 101 is controlled to operate, so that the DC-DC conversion circuit can adjust a voltage of the direct current output by the AC-DC conversion circuit, to provide a voltage-adapted direct current for the storage battery 102, and the storage battery 102 can store the direct current to implement a charging function.

In another possible implementation, the power conversion circuit 101 may alternatively be a DC-DC conversion circuit. The electric vehicle 110 may further include a load 103. The load 103 may be a vehicle-mounted device, a power system, or the like of the electric vehicle 110. For example, a power switching transistor of the DC-DC conversion circuit in the power conversion circuit 101 is controlled to operate, so that the power conversion circuit 101 can adjust a voltage of a direct current output by the storage battery, and then output the direct current to the load 103, to provide the voltage-adapted direct current for the load 103.

The semiconductor device provided in embodiments of this application may be a MOSFET device with a trench gate structure. This can alleviate a conflict between an on-resistance and a capacitance, thereby improving performance of the semiconductor device. For example, the semiconductor device provided in embodiments of this application may be used in the power conversion circuit 101 in the vehicle, and may be used as a power switching transistor in an AC-DC converter and/or a power switching transistor in a DC-DC converter. Because the semiconductor device provided in embodiments of this application has good performance, when the semiconductor device is used in the AC-DC converter and/or the DC-DC converter, performance of the AC-DC converter and/or the DC-DC converter can be improved. This can improve performance of the entire circuit.

The semiconductor device provided in embodiments of this application may also be used in various electronic devices, for example, may be used in an electronic device with a logic device, a storage device, or the like. For example, the electronic device may be a smartphone, a smart television, a notebook computer, a personal digital assistant (personal digital assistant, PDA), a wearable device (for example, a smartwatch, smart glasses, or a smart band) having a wireless communication function, or the like. It should be noted that the semiconductor device provided in embodiments of this application is intended to include but is not limited to being used in these electronic devices and any other suitable type of electronic devices.

FIG. 2 is a diagram of a structure of an electronic device according to an embodiment of this application. As shown in FIG. 2, the electronic device 120 provided in this embodiment of this application may include the power conversion circuit 101 and the load 103. The power conversion circuit 101 is electrically connected to the load 103. For example, the electronic device 120 may be any power consumption device, for example, a smartphone, a smart television, a notebook computer, a personal digital assistant (personal digital assistant, PDA), a wearable device (for example, a smartwatch, smart glasses, or a smart band) having a wireless communication function, an on-board micro controller unit (micro controller unit, MCU), an on-board battery charger (on-board battery charger, OBC), and the like. It should be noted that a specific type of the electronic device is not limited in this application.

In some embodiments, the power conversion circuit 101 may be a direct current (direct current, DC)-direct current power conversion circuit, and is configured to perform boost or buck processing on the direct current and then output the direct current, to supply power to the load 103. For example, the power conversion circuit 101 may convert a direct current (for example, 48 V) output by a power supply 130 into a direct current used for all types of loads 103, and output the direct current to the load 103, for the load 103 to operate. The power supply 130 and the load 103 are not limited in this application. The power supply 130 may be any device or element that can output a direct current. For example, the power supply 130 may be a battery (for example, a storage battery). In this case, the power conversion circuit 101 may receive a battery voltage provided by the battery, convert the battery voltage into an operating voltage of the load 103, and then output the operating voltage to the load 103. The load 103 may be any functional module that uses a direct current. For example, the load 103 may be a processor, a chip, or the like.

Still refer to FIG. 2. The power conversion circuit 101 may include a DC-DC converter 1011. During specific operation, a MOSFET in the DC-DC converter 1011 operates at a specific switching frequency, so that the DC-DC converter 1011 performs boost or buck processing on a direct current of the power supply 130, and then outputs the direct current to the load 103 to provide the direct current with the operating voltage. For example, the DC-DC converter 1011 may be a buck (buck) converter, a boost (boost) converter, a half-bridge converter, a full-bridge converter, an inductor-inductor-capacitor (inductor-inductor-capacitor, LLC) resonant converter, or the like.

The semiconductor device provided in embodiments of this application may be a MOSFET device with a trench gate structure. This can alleviate a conflict between an on-resistance and a capacitance, thereby improving performance of the semiconductor device. For example, the semiconductor device provided in embodiments of this application may be used in the DC-DC converter 1011, and may be used as the MOSFET in the DC-DC converter 1011. Because the semiconductor device provided in embodiments of this application has good device performance, when the semiconductor device is used in the MOSFET in the DC-DC converter 1011, performance of the DC-DC converter 1011 can be improved. This improves performance of the entire electronic device.

It should be noted that the foregoing scenario descriptions are merely examples for describing some implementable application modes of the semiconductor device in this application. A specific application scenario of the semiconductor device provided in embodiments of this application is not limited in this application, and may be determined based on an actual application requirement.

The foregoing describes the application scenario of this application. The following describes in detail specific implementations of the semiconductor device and the manufacturing method thereof, the power conversion circuit, and the vehicle that are provided in embodiments of this application with reference to accompanying drawings.

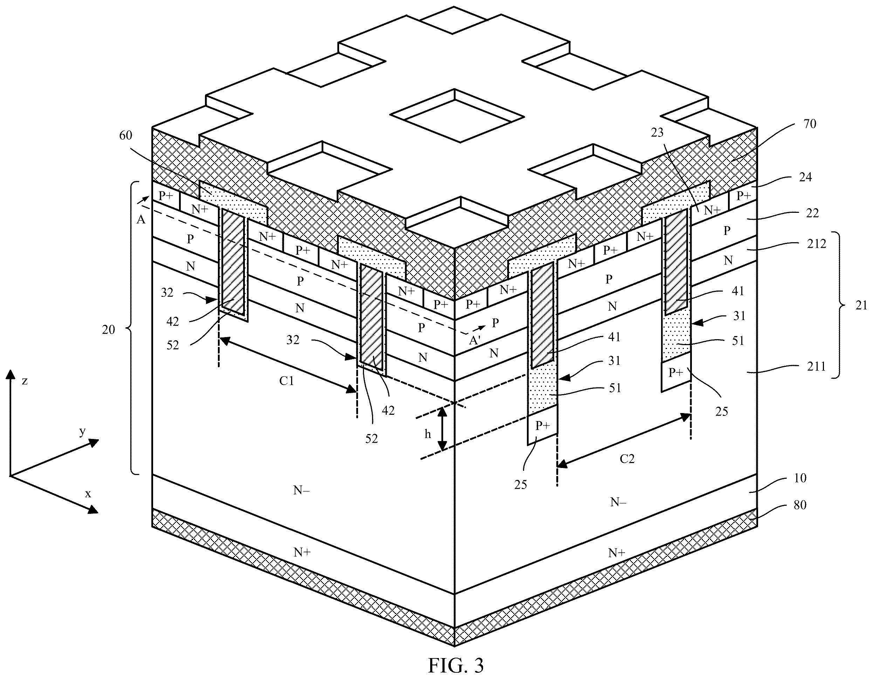

FIG. 3 is a diagram of a structure of a semiconductor device according to an embodiment of this application. As shown in FIG. 3, the semiconductor device provided in this embodiment of this application may include an N-type semiconductor substrate 10, an epitaxial layer 20 disposed on the semiconductor substrate 10, and a first gate 41 and a second gate 42 that are connected to each other. The first gate 41 extends in a first direction x, the second gate 42 extends in a second direction y, and the first direction x and the second direction y are two directions that are parallel to a plane on which the semiconductor substrate 10 is located and that intersect with each other. The first gate 41 and the second gate 42 are respectively located in different grooves in the epitaxial layer 20. For example, the first gate 41 may be located in a first groove 31, and the second gate 42 may be located in a second groove 32. A first gate dielectric 51 is filled between the first gate 41 and the first groove 31, and the first gate 41 is isolated from the second groove 32 through the first gate dielectric 51. A second gate dielectric 52 is filled between the second gate 42 and the second groove 32, and the second gate 42 is isolated from the second groove 32 through the second gate dielectric 52. In a direction perpendicular to the plane on which the semiconductor substrate 10 is located (for example, a third direction z in the figure), a thickness of the first gate dielectric 51 is greater than a thickness of the second gate dielectric 52.

The semiconductor device in this embodiment of this application may be a SiC MOSFET device, and each of the semiconductor substrate 10 and the epitaxial layer 20 may include a silicon carbide (SiC) material. The semiconductor substrate 10 may be a monocrystalline silicon carbide substrate doped with a pentavalent element. The epitaxial layer 20 may include a SiC material doped with a corresponding impurity, and the epitaxial layer 20 may be manufactured by using an epitaxial growth process.

It should be noted that, in accompanying drawings of this application, a layer or region with a prefix of N or P indicates that electrons or holes are majority carriers. In addition, "+" marked at N or P indicates that doping concentration is higher than doping concentration of a layer or region that is not marked with +, and a larger quantity of "+" indicates higher doping concentration. In addition, N or P including a same quantity of "+" indicates that doping concentration is similar doping concentration, and is not limited to same doping concentration. In addition, "-" marked at N or P indicates that doping concentration is lower than doping concentration of a layer or region that is not marked with -, and a larger quantity of "-" indicates lower doping concentration. N or P including a same quantity of "-" indicates doping concentration is similar doping concentration, and is not limited to same doping concentration. In addition, it should be further noted that, in this application, comparison between doping concentration of two regions is merely comparison between concentration of impurities doped into the two regions; and compositions of the impurities and substrates doped with the impurities are not limited. In other words, the compositions of the impurities may be the same or may be different, and materials of the substrates doped with the impurities may be the same or may be different.

The semiconductor device in this embodiment of this application is a SiC MOSFET device with a trench gate structure. A plurality of grooves are disposed in the epitaxial layer 20, and a gate is disposed in the groove. The gate may be embedded inside the epitaxial layer 20, so that a conductive channel direction of the semiconductor device is a vertical direction. This increases conductive channel density of the semiconductor device, thereby reducing an on-resistance. In addition, the semiconductor device in this embodiment of this application includes the first gate 41 and the second gate 42 that are connected to each other. The first gate 41 extends in the first direction x, and the second gate 42 extends in the second direction y. This can further increase the conductive channel density, thereby further reducing the on-resistance. In addition, in this embodiment of this application, in the direction perpendicular to the plane on which the semiconductor substrate 10 is located, the thickness of the first gate dielectric 51 is greater than the thickness of the second gate dielectric 52. The thicker first gate dielectric 51 is disposed, so that a capacitance of the semiconductor device can be reduced. This can alleviate a conflict between an on-resistance and a capacitance, thereby improving performance of the semiconductor device.

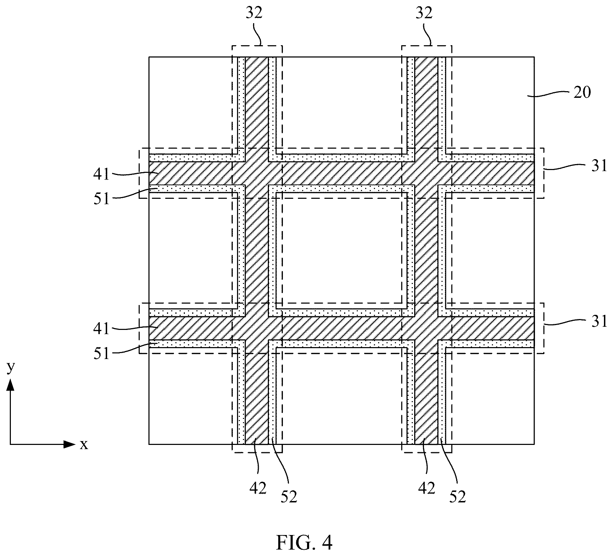

FIG. 4 is a diagram of a cross section at a dashed line AA' in FIG. 3. With reference to FIG. 3 and FIG. 4, a plurality of first grooves 31 and a plurality of second grooves 32 are disposed in the epitaxial layer 20; the first grooves 31 extend in the first direction x and are arranged in the second direction y; the second grooves 32 extend in the second direction y and are arranged in the first direction x; the first grooves 31 and the second grooves 32 intersect with each other; and the first grooves 31 and the second grooves 32 extend to the inside of the epitaxial layer 20 in the third direction z from a surface of a side that is of the epitaxial layer 20 and that is away from the semiconductor substrate 10. The third direction z is the direction perpendicular to the plane on which the semiconductor substrate 10 is located. Optionally, the first direction x, the second direction y, and the third direction z may be perpendicular to each other. The first gate 41 is located in the first groove 31, and the second gate 42 is located in the second groove 32. For example, one first gate 41 may be disposed in each first groove 31, and one second gate 42 may be disposed in each second groove 32. The first gate dielectric 51 is filled between the first gate 41 and the first groove 31, and the first gate 41 is isolated from the first groove 31 through the first gate dielectric 51. The second gate dielectric 52 is filled between the second gate 42 and the second groove 32, and the second gate 42 is isolated from the second groove 32 through the second gate dielectric 52. The thickness of the first gate dielectric 51 in the third direction z is greater than the thickness of the second gate dielectric 52 in the third direction z.

In other words, the first gate 41 is filled into the first groove 31 separated by the first gate dielectric 51, and the second gate 42 is filled into the second groove 32 separated by the second gate dielectric 52, so that the first gate 41 and the second gate 42 are embedded inside the epitaxial layer 20. Therefore, the semiconductor device in this embodiment of this application is a SiC MOSFET device with a groove structure.

In a possible implementation, the first gate 41 and the second gate 42 may be made of a polycrystalline silicon material, or the first gate 41 and the second gate 42 may be made of a metal material like tungsten (W), aluminum (Al), titanium (Ti), copper (Cu), molybdenum (Mo), or platinum (Pt). Certainly, the first gate 41 and the second gate 42 may alternatively be made of another material with good conductivity. This is not limited herein.

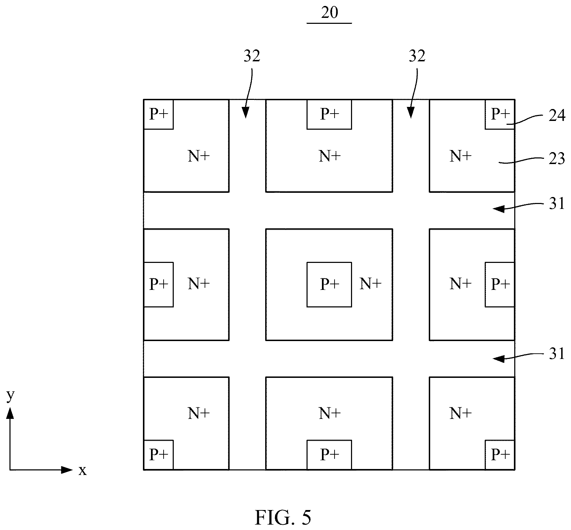

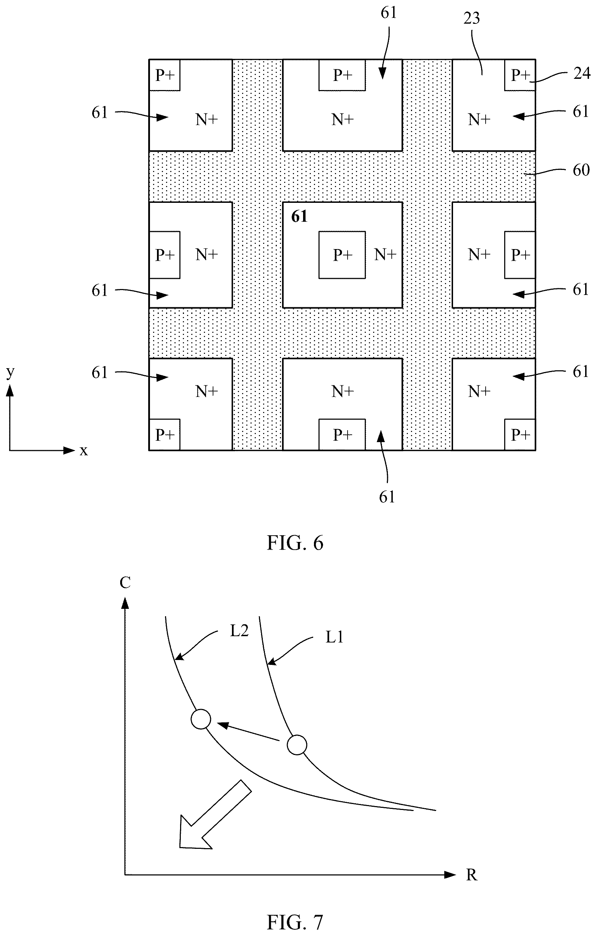

In this embodiment of this application, the semiconductor device may further include an interlayer dielectric layer 60, a source 70, and a drain 80. FIG. 5 is a top view of a structure of the epitaxial layer according to this embodiment of this application. The diagram shown in FIG. 5 shows a surface of a side that is of the epitaxial layer and that is away from the semiconductor substrate. FIG. 6 is a top view of a structure of the interlayer dielectric layer according to this embodiment of this application. The diagram shown in FIG. 6 is obtained by covering the epitaxial layer shown in FIG. 5 with the interlayer dielectric layer. With reference to FIG. 3, FIG. 5, and FIG. 6, the interlayer dielectric layer 60 covers a surface of a side that is of the first gate 41 and the second gate 42 and that is away from the semiconductor substrate 10, a plurality of contact holes 61 are disposed in the interlayer dielectric layer 60, and orthographic projections of the contact holes 61 on the semiconductor substrate 10 do not overlap orthographic projections of the first gate 41 and the second gate 42 on the semiconductor substrate 10. The source 70 is disposed on a side that is of the interlayer dielectric layer 60 and that is away from the semiconductor substrate 10, and the source 70 is in contact with the epitaxial layer 20 through the contact holes 61. The drain 80 is located on a side that is of the semiconductor substrate 10 and that is away from the epitaxial layer 20.

It can be clearly seen through comparison between FIG. 5 and FIG. 6 that the plurality of contact holes 61 in the interlayer dielectric layer 60 may expose some regions of the epitaxial layer 20, so that the source 70 can be in contact with the epitaxial layer 20 through the contact holes 61. Still refer to FIG. 3, FIG. 5, and FIG. 6. The orthographic projections of the contact holes 61 on the semiconductor substrate 10 do not overlap the orthographic projections of the first gate 41 and the second gate 42 on the semiconductor substrate 10. This can prevent the source 70 from being in contact with the first gate 41 and the second gate 42.

In a possible implementation, the interlayer dielectric layer 60 may include a dielectric material. The dielectric material may include but is not limited to silicon dioxide (SiO2), silicon oxynitride (SiNO), silicon oxycarbide (SiCO), and silicon nitride (SiNx). The source 70 and the drain 80 may be made of a metal material. For example, the metal material may include but is not limited to W, Al, Ti, Cu, Mo, or Pt.

FIG. 7 is a diagram of characteristic comparison between a semiconductor device in an embodiment of this application and a semiconductor device in the conventional technology. As shown in FIG. 7, a horizontal coordinate R indicates an on-resistance, a vertical coordinate C indicates a capacitance, a curve L1 is a characteristic curve of the semiconductor device in the conventional technology, and a curve L2 is a characteristic curve of the semiconductor device in this embodiment of this application. It can be clearly seen through comparison between the curve L1 and the curve L2 that the curve L2 tends to be closer to the lower left corner than the curve L1 (to be specific, the on-resistance and the capacitance tend to be smaller). In other words, at locations with a same on-resistance, a capacitance on the curve L2 is smaller than that on the curve L1, and at locations with a same capacitance, an on-resistance on the curve L2 is also smaller than that on the curve L1. In this way, in the procedure of reducing the on-resistance, an increase amplitude of the capacitance on the curve L2 is smaller, and the capacitance of the semiconductor device is not significantly increased with an increase in groove density. Therefore, compared with the semiconductor device in the conventional technology, the semiconductor device in this embodiment of this application can alleviate the conflict between the on-resistance and the capacitance. In this way, both the on-resistance and the capacitance are small, and performance of the semiconductor device is better.

In a possible implementation, as shown in FIG. 3, a depth of each first groove 31 may be greater than a depth of each second groove 32. For example, in FIG. 3, a difference between the depth of the first groove 31 and the depth of the second groove 32 may be h. A thickness of each first gate 41 in the third direction z may be consistent with a thickness of each second gate 42 in the third direction z. Therefore, the thickness of the first gate dielectric 51 in the third direction z may be greater than the thickness of the second gate dielectric 52 in the third direction z. For example, in FIG. 3, a difference between the thickness of the first gate dielectric 51 and the thickness of the second gate dielectric 52 may also be h. A part that is of the first gate dielectric 51 and that exceeds the second gate dielectric 52 in thickness may be disposed at the bottom of the first groove 31, to facilitate manufacturing.

That the thicknesses of the first gate 41 and the second gate 42 in the third direction z are consistent means that the first gate 41 and the second gate 42 are equal within a process error range. In a manufacturing procedure, the first gate 41 and the second gate 42 may be manufactured by using a same process. In this way, process steps can be reduced, and process costs can be reduced. Certainly, in some cases, when the first gate 41 and the second gate 42 are manufactured by using different processes, thicknesses of the first gate 41 and the second gate 42 in the third direction z may alternatively be unequal, provided that the thickness of the first gate dielectric 51 in the third direction z is greater than the thickness of the second gate dielectric 52 in the third direction z.

During specific implementation, the depths of the first grooves 31 may be equal within a process error range. In this way, in a manufacturing procedure, the first grooves 31 may be manufactured by using a same process. Similarly, the depths of the second grooves 32 may be equal within a process error range. In this way, the second grooves 32 may be manufactured by using a same process. In this way, process steps can be reduced, and process costs can be reduced.

Still refer to FIG. 3. A spacing between two adjacent first grooves 31 in the second direction y is C2, and a spacing between two adjacent second grooves 32 in the first direction x is C1. During specific setting, the spacing C1 and the spacing C2 may be set based on an actual requirement. The spacing C1 may be greater than the spacing C2. Alternatively, the spacing C1 may be equal to the spacing C2. Alternatively, the spacing C1 may be less than the spacing C2. In some embodiments of this application, the first grooves 31 may be evenly spaced, or may be unevenly spaced; and the second grooves 32 may be evenly spaced, or may be unevenly spaced.

In this embodiment of this application, as shown in FIG. 3, the epitaxial layer 20 may include an N-type semiconductor region 21 and a first P-type semiconductor region 22. The N-type semiconductor region 21 may be doped with an N-type impurity like nitrogen (N), phosphorus (P), or arsenic (As), and the first P-type semiconductor region 22 may be doped with a P-type impurity like boron (B), aluminum (Al), or gallium (Ga).

The first P-type semiconductor region 22 is located on a side that is of the N-type semiconductor region 21 and that is away from the semiconductor substrate 10. Each first groove 31 and each second groove 32 penetrate the first P-type semiconductor region 22 in the third direction z, and extend into the N-type semiconductor region 21. In this way, the first gate 41 and the second gate 42 can form the SiC MOSFET device with the trench gate structure together with the first P-type semiconductor region 22 through the gate dielectric (the first gate dielectric 51 or the second gate dielectric 52).

In some embodiments of this application, with reference to FIG. 3, FIG. 5, and FIG. 6, the epitaxial layer 20 may further include a plurality of P-type connection regions 24 and a source region 23 that are disposed on a same layer. Each P-type connection region 24 corresponds to a location of one contact hole 61, an orthographic projection of the P-type connection region 24 on the semiconductor substrate 10 falls within a range of an orthographic projection of the corresponding contact hole 61 on the semiconductor substrate 10, and the P-type connection region 24 connects the first P-type semiconductor region 22 to the source 70. Doping concentration of the P-type connection region 24 may be greater than doping concentration of the first P-type semiconductor region 22, so that the P-type connection region 24 has good conductivity. The source region 23 is a region other than the plurality of first grooves 31, the plurality of second grooves 32, and the plurality of P-type connection regions 24 on the layer on which the source region 23 is located. For example, a part of the source region 23 may be covered by the interlayer dielectric layer 60, and another part may be electrically connected to the source 70.

During specific implementation, an N-type impurity like nitrogen (N), phosphorus (P), or arsenic (As) may be injected, by using an ion injection process, into a region in which the source region 23 is to be formed, to form the source region 23; and a P-type impurity like boron (B), aluminum (Al), or gallium (Ga) is injected, by using the ion injection process, into a region in which the P-type connection region 24 is to be formed, to form the P-type connection region 24.

The first groove 31 (or the second groove 32) has the first P-type semiconductor region 22 on both sides in the second direction y (or the first direction x). When the semiconductor device operates, under control of the first gate 41 (or the second gate 42), the first P-type semiconductor region 22 may form an N-type inversion channel, so that the source 70 is connected to the drain 80 through a conduction path of the source region 23, the first P-type semiconductor region 22, the N-type semiconductor region 21, and the semiconductor substrate 10.

During specific implementation, doping concentration of the semiconductor substrate 10 is large. For example, the doping concentration of the semiconductor substrate 10 may be greater than doping concentration of the N-type semiconductor region 21, so that the semiconductor substrate 10 has good conductivity. In this way, the semiconductor substrate 10 may be used as a drain region of the semiconductor device. Doping concentration of the source region 23 is also large. For example, the doping concentration of the source region 23 may be greater than the doping concentration of the N-type semiconductor region 21, so that the source region 23 has good conductivity. In this way, when the semiconductor device operates, it is convenient to connect the source 70 to the drain 80. This reduces the on-resistance of the semiconductor device.

The semiconductor device in this embodiment of this application is the SiC MOSFET device with the trench gate structure. At the bottom and corners of the first groove 31 and the second groove 32, the gate dielectric (the first gate dielectric 51 or the second gate dielectric 52) bears high electric field strength when the semiconductor device operates, and is a weak point of electric field breakdown, easily resulting in a failure of long-term operating reliability of the semiconductor device. As shown in FIG. 3, to effectively shield the gate dielectric from a high electric field stress, the epitaxial layer 20 in this embodiment of this application may further include a second P-type semiconductor region 25. The second P-type semiconductor region 25 is located on a side that is of the first groove 31 and that is close to the semiconductor substrate 10. The second P-type semiconductor region 25 is electrically connected to the source 70. When the semiconductor device operates, a voltage is loaded to the source 70. Because the second P-type semiconductor region 25 is electrically connected to the source 70, the voltage loaded to the source 70 is input to the second P-type semiconductor region 25, so that the second P-type semiconductor region 25 also has the corresponding voltage. This can effectively shield an electric field of the gate dielectric at the bottom of the first groove 31 and an electric field of the gate dielectric at the bottom of the second groove 32, thereby improving operating robustness of the semiconductor device.

For example, a thickness of the second P-type semiconductor region 25 in the third direction z may be less than 1 µm. For example, the thickness of the second P-type semiconductor region 25 in the third direction z may be 0.3 µm to 0.8 µm. Certainly, a thickness of the second P-type semiconductor region 25 in the third direction z may alternatively be greater than 1 µm. This is not limited herein. Optionally, the second P-type semiconductor region 25 may be doped with a P-type impurity like boron (B), aluminum (Al), or gallium (Ga). To make the second P-type semiconductor region 25 have good conductivity, doping concentration of the second P-type semiconductor region 25 may be set to be large. For example, the doping concentration of the second P-type semiconductor region 25 may be greater than the doping concentration of the first P-type semiconductor region 22.

In some application scenarios, the source 70 of the semiconductor device may be grounded, and the drain 80 may be electrically connected to another element. Because the second P-type semiconductor region 25 is electrically connected to the source 70, a voltage of the second P-type semiconductor region 25 is also a ground voltage (0 V). This can effectively shield an electric field of the gate dielectric at the bottom of the first groove 31 and an electric field of the gate dielectric at the bottom of the second groove 32, thereby improving operating robustness of the semiconductor device. In some other application scenarios, the source 70 of the semiconductor device may be electrically connected to another element, and the drain 80 is also electrically connected to the another element. In this case, a voltage of the source 70 is a voltage (which may not be 0) of an input signal of the another element. Because the second P-type semiconductor region 25 is electrically connected to the source 70, a voltage of the second P-type semiconductor region 25 is also the voltage of the input signal. This can effectively shield an electric field of the gate dielectric at the bottom of the first groove 31 and an electric field of the gate dielectric at the bottom of the second groove 32, thereby improving operating robustness of the semiconductor device.

Still refer to FIG. 3. In a possible implementation, the N-type semiconductor region 21 may include a first N-type semiconductor region 211 and a second N-type semiconductor region 212. The second N-type semiconductor region 212 is located between the first N-type semiconductor region 211 and the first P-type semiconductor region 22, and doping concentration of the second N-type semiconductor region 212 is greater than doping concentration of the first N-type semiconductor region 211. Each first groove 31 and each second groove 32 penetrate the second N-type semiconductor region 212 in the third direction z, and extend into the first N-type semiconductor region 211. The second P-type semiconductor region 25 may be located in the first N-type semiconductor region 211.

Each of the first N-type semiconductor region 211 and the second N-type semiconductor region 212 may include an N-type impurity like nitrogen (N), phosphorus (P), or arsenic (As). The doping concentration of the first N-type semiconductor region 211 is small, so that voltage withstand performance of the semiconductor device can be improved. The doping concentration of the second N-type semiconductor region 212 is large, so that the on-resistance of the semiconductor device can be reduced.

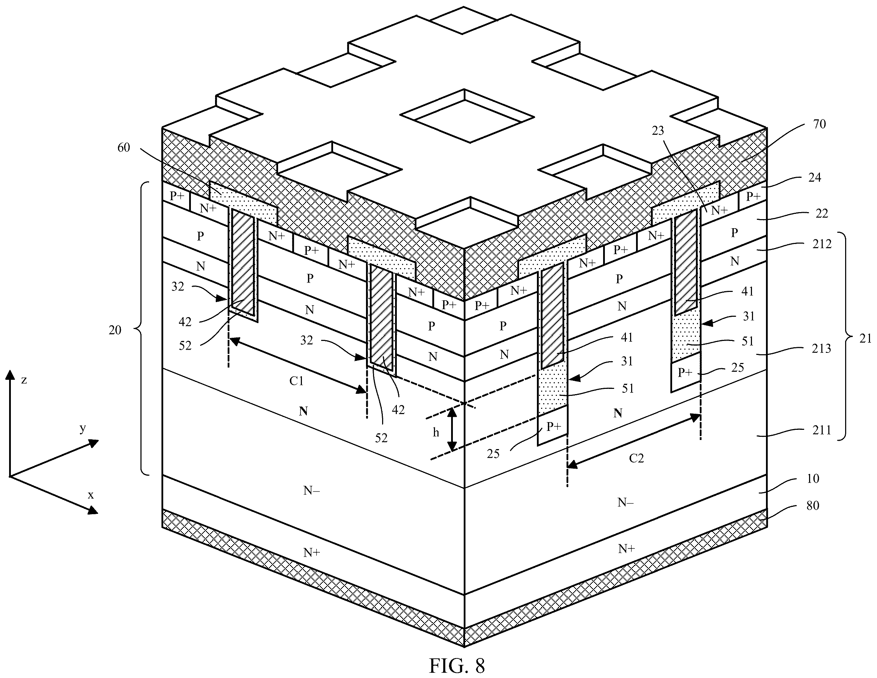

FIG. 8 is a diagram of another structure of a semiconductor device according to an embodiment of this application. As shown in FIG. 8, in another possible implementation, the N-type semiconductor region 21 may include a first N-type semiconductor region 211, a second N-type semiconductor region 212, and a third N-type semiconductor region 213. The second N-type semiconductor region 212 is located on a side that is of the first N-type semiconductor region 211 and that is away from the semiconductor substrate 10, and the third N-type semiconductor region 213 is located between the first N-type semiconductor region 211 and the second N-type semiconductor region 212. Doping concentration of the second N-type semiconductor region 212 is greater than doping concentration of the first N-type semiconductor region 211, and doping concentration of the third N-type semiconductor region 213 is greater than the doping concentration of the first N-type semiconductor region 211. Each first groove and each second groove penetrate the second N-type semiconductor region 212 in the third direction, and extend into the third N-type semiconductor region 213. The second P-type semiconductor region 25 is located in the third N-type semiconductor region 213.

Each of the first N-type semiconductor region 211, the second N-type semiconductor region 212, and the third N-type semiconductor region 213 may include an N-type impurity like nitrogen (N), phosphorus (P), or arsenic (As). The doping concentration of the first N-type semiconductor region 211 is small, so that voltage withstand performance of the semiconductor device can be improved. The doping concentration of the second N-type semiconductor region 212 is large, so that the on-resistance of the semiconductor device can be reduced. In addition, the doping concentration of the third N-type semiconductor region 213 is large, so that the on-resistance of the semiconductor device can be further reduced.

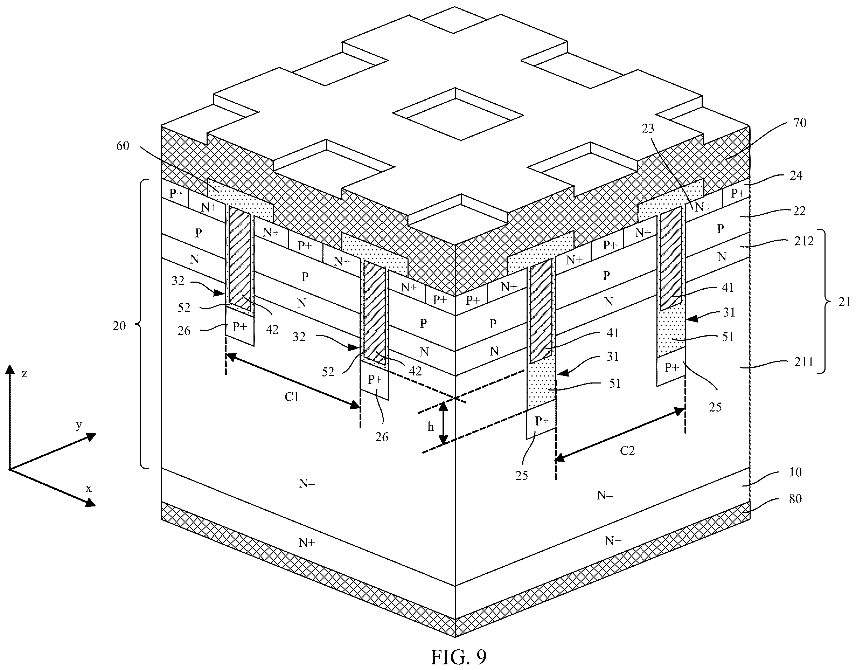

FIG. 9 is a diagram of another structure of a semiconductor device according to an embodiment of this application. As shown in FIG. 9, in some other embodiments of this application, the epitaxial layer 20 may further include a third P-type semiconductor region 26. The third P-type semiconductor region 26 is located on a side that is of the second groove 32 and that is close to the semiconductor substrate 10, and the third P-type semiconductor region 26 is electrically connected to the source 70. That is, compared with the semiconductor device shown in FIG. 3, in the semiconductor device shown in FIG. 9, the third P-type semiconductor region 26 is disposed at the bottom of the second groove 32. In other words, both the second P-type semiconductor region 25 at the bottom of the first groove 31 and the third P-type semiconductor region 26 at the bottom of the second groove 32 are electrically connected to the source 70. In this way, when the semiconductor device operates, a voltage is loaded to the source 70. Because both the second P-type semiconductor region 25 and the third P-type semiconductor region 26 are electrically connected to the source 70, the voltage loaded to the source 70 is input to the second P-type semiconductor region 25 and the third P-type semiconductor region 26, so that the second P-type semiconductor region 25 and the third P-type semiconductor region 26 also have the corresponding voltage. This can effectively shield an electric field of the gate dielectric at the bottom of the first groove 31 and an electric field of the gate dielectric at the bottom of the second groove 32, thereby improving operating robustness of the semiconductor device.

Optionally, the third P-type semiconductor region 26 may be doped with a P-type impurity like boron (B), aluminum (Al), or gallium (Ga). To make the third P-type semiconductor region 26 have good conductivity, doping concentration of the third P-type semiconductor region 26 may be set to be large. For example, the doping concentration of the third P-type semiconductor region 26 may be greater than the doping concentration of the first P-type semiconductor region 22.

In some application scenarios, the source 70 of the semiconductor device may be grounded, and the drain 80 may be electrically connected to another element. Because the second P-type semiconductor region 25 and the third P-type semiconductor region 26 are electrically connected to the source 70, a voltage of the second P-type semiconductor region 25 and a voltage of the third P-type semiconductor region 26 are also a ground voltage (0 V). This can effectively shield an electric field of the gate dielectric at the bottom of the first groove 31 and an electric field of the gate dielectric at the bottom of the second groove 32, thereby improving operating robustness of the semiconductor device. In some other application scenarios, the source 70 of the semiconductor device may be electrically connected to another element, and the drain 80 is also electrically connected to the another element. In this case, a voltage of the source 70 is a voltage (which may not be 0) of an input signal of the another element. Because the second P-type semiconductor region 25 and the third P-type semiconductor region 26 are electrically connected to the source 70, a voltage of the second P-type semiconductor region 25 and a voltage of the third P-type semiconductor region 26 are also the voltage of the input signal. This can effectively shield an electric field of the gate dielectric at the bottom of the first groove 31 and an electric field of the gate dielectric at the bottom of the second groove 32, thereby improving operating robustness of the semiconductor device.

Still refer to FIG. 9. A thickness of the third P-type semiconductor region 26 in the third direction z may be less than 1 µm, and thicknesses of the second P-type semiconductor region 25 and the third P-type semiconductor region 26 in the third direction z may be approximately equal within a process error range, so that the second P-type semiconductor region 25 and the third P-type semiconductor region 26 may be manufactured together by using a same manufacturing process. This can reduce process steps, and reduce manufacturing costs.

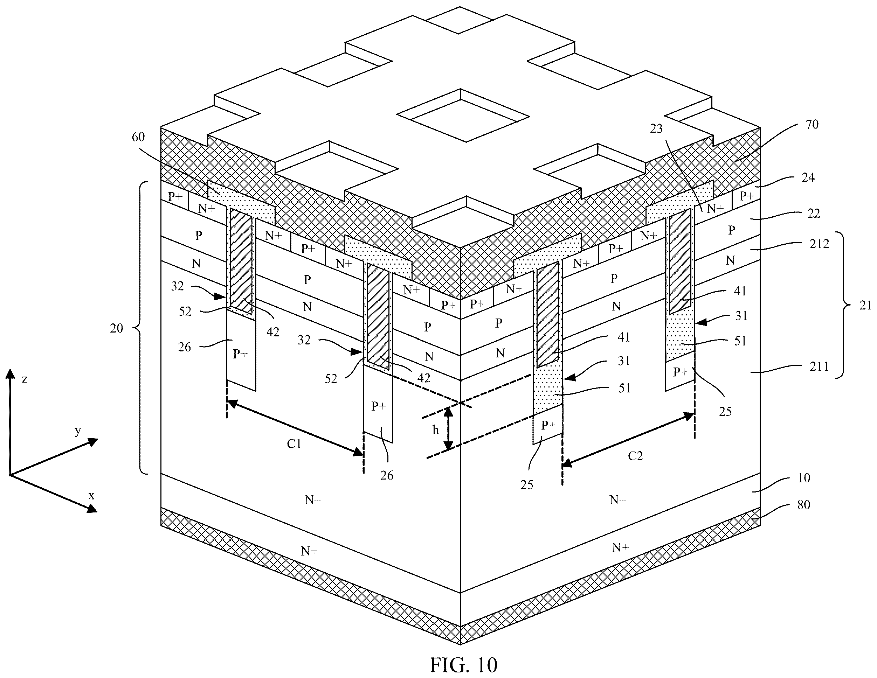

FIG. 10 is a diagram of another structure of a semiconductor device according to an embodiment of this application. As shown in FIG. 10, a thickness of the third P-type semiconductor region 26 in the third direction z may alternatively be greater than 1 µm, and the thickness of the third P-type semiconductor region 26 in the third direction z may be greater than a thickness of the second P-type semiconductor region 25 in the third direction z. In a manufacturing procedure, the second P-type semiconductor region 25 and the third P-type semiconductor region 26 may be separately manufactured by using different process steps.

As shown in FIG. 9 and FIG. 10, in a possible implementation, the N-type semiconductor region 21 may include a first N-type semiconductor region 211 and a second N-type semiconductor region 212. The second N-type semiconductor region 212 is located between the first N-type semiconductor region 211 and the first P-type semiconductor region 22, and doping concentration of the second N-type semiconductor region 212 is greater than doping concentration of the first N-type semiconductor region 211. Each first groove 31 and each second groove 32 penetrate the second N-type semiconductor region 212 in the third direction z, and extend into the first N-type semiconductor region 211. The second P-type semiconductor region 25 and the third P-type semiconductor region 26 are located in the first N-type semiconductor region 211.

Each of the first N-type semiconductor region 211 and the second N-type semiconductor region 212 may include an N-type impurity like nitrogen (N), phosphorus (P), or arsenic (As). The doping concentration of the first N-type semiconductor region 211 is small, so that voltage withstand performance of the semiconductor device can be improved. The doping concentration of the second N-type semiconductor region 212 is large, so that the on-resistance of the semiconductor device can be reduced.

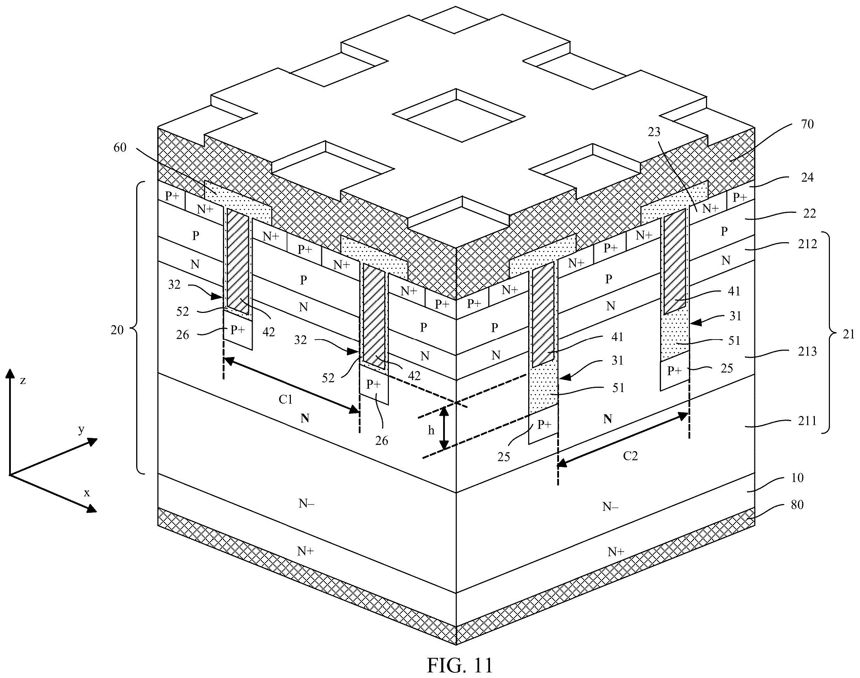

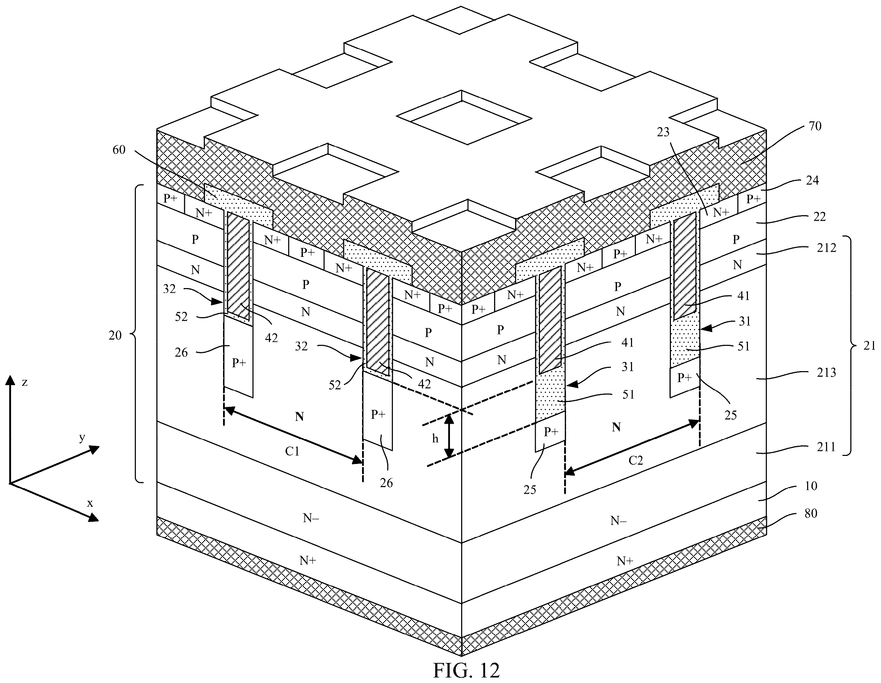

FIG. 11 is a diagram of another structure of a semiconductor device according to an embodiment of this application. In FIG. 11, a thickness of the third P-type semiconductor region 26 in the third direction z is small. For example, thicknesses of the second P-type semiconductor region 25 and the third P-type semiconductor region 26 in the third direction z may be approximately equal within a process error range. FIG. 12 is a diagram of another structure of a semiconductor device according to an embodiment of this application. In FIG. 12, a thickness of the third P-type semiconductor region 26 in the third direction z is large. For example, the thickness of the third P-type semiconductor region 26 in the third direction z may be greater than a thickness of the second P-type semiconductor region 25 in the third direction z.

As shown in FIG. 11 and FIG. 12, in another possible implementation, the N-type semiconductor region 21 includes a first N-type semiconductor region 211, a second N-type semiconductor region 212, and a third N-type semiconductor region 213. The second N-type semiconductor region 212 is located on a side that is of the first N-type semiconductor region 211 and that is away from the semiconductor substrate 10, and the third N-type semiconductor region 213 is located between the first N-type semiconductor region 211 and the third N-type semiconductor region 213. Doping concentration of the second N-type semiconductor region 212 is greater than doping concentration of the first N-type semiconductor region 211, and doping concentration of the third N-type semiconductor region 213 is greater than the doping concentration of the first N-type semiconductor region 211. Each first groove 31 and each second groove 32 penetrate the second N-type semiconductor region 212 in the third direction z, and extend into the third N-type semiconductor region 213. The second P-type semiconductor region 25 and the third P-type semiconductor region 26 are located in the third N-type semiconductor region.

Each of the first N-type semiconductor region 211, the second N-type semiconductor region 212, and the third N-type semiconductor region 213 may include an N-type impurity like nitrogen (N), phosphorus (P), or arsenic (As). The doping concentration of the first N-type semiconductor region 211 is small, so that voltage withstand performance of the semiconductor device can be improved. The doping concentration of the second N-type semiconductor region 212 and the doping concentration of the third N-type semiconductor region 213 are large, so that the on-resistance of the semiconductor device can be reduced.

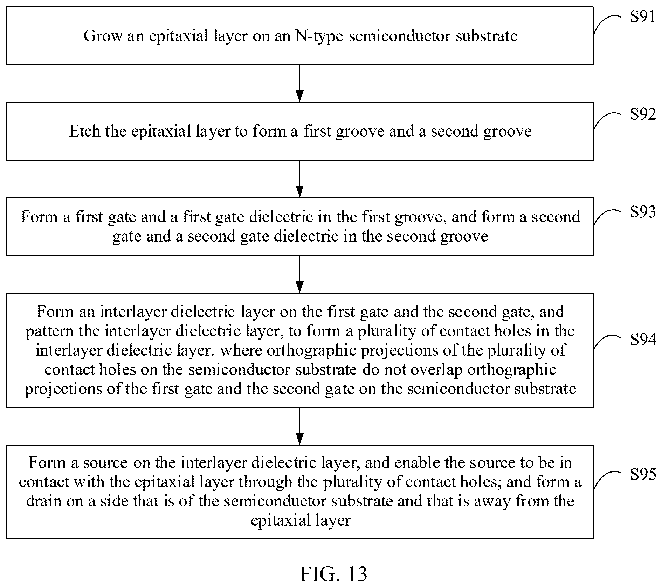

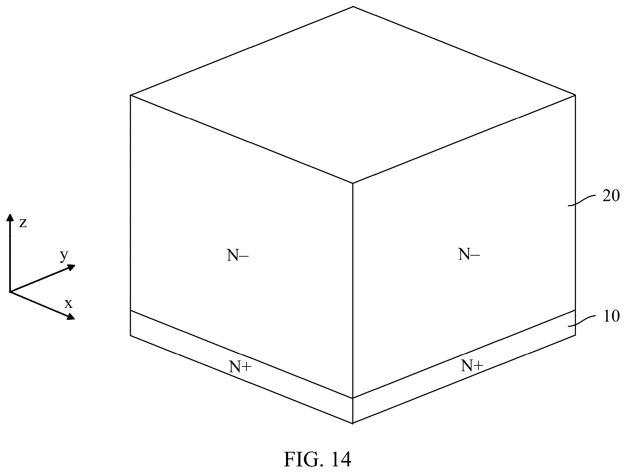

The foregoing describes basic structures of the semiconductor device in embodiments of this application. Based on a same technical idea, embodiments of this application further provide a manufacturing method of any one of the foregoing semiconductor devices. FIG. 13 is a flowchart of a manufacturing method of a semiconductor device according to an embodiment of this application. FIG. 14 to FIG. 24 are diagrams of structures corresponding to steps in the manufacturing method according to this embodiment of this application.

Refer to FIG. 13. The semiconductor device shown in FIG. 3 is used as an example. The manufacturing method of the semiconductor device provided in this embodiment of this application may include the following steps.

S91: Refer to FIG. 14. Grow an epitaxial layer 20 on an N-type semiconductor substrate 10.

For example, the N-type semiconductor substrate 10 may be a monocrystalline silicon carbide substrate doped with a pentavalent element. A SiC material doped with an N-type impurity may be grown on the semiconductor substrate 10 by using an epitaxial process, to obtain the epitaxial layer 20.

In a possible implementation, step S91 may specifically include the following steps.

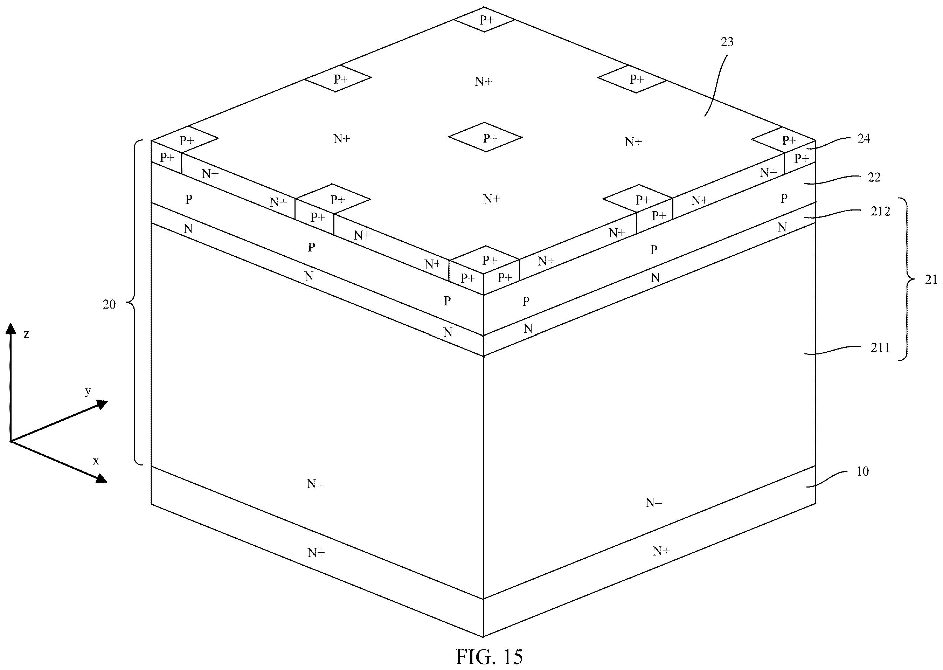

Refer to FIG. 15. An N-type semiconductor region 21 is formed on the semiconductor substrate 10 by using an epitaxial process, and ions are injected into the N-type semiconductor region 21 by using an ion injection process, to form the first P-type semiconductor region 22. For example, the N-type semiconductor region 21 may include an N-type impurity like nitrogen (N), phosphorus (P), or arsenic (As). A P-type impurity like boron (B), aluminum (Al), or gallium (Ga) may be injected into the epitaxial layer 20, to obtain the P-type semiconductor region 22. During specific implementation, a first N-type semiconductor region 211 may be formed by using an epitaxial process, and then, an N-type impurity is injected into a surface of the first N-type semiconductor region 211, to form a second N-type semiconductor region 212 with large doping concentration on the surface of the first N-type semiconductor region 211.

Still refer to 15. Ions are injected into a surface of the epitaxial layer 20 by using the ion injection process, to form a plurality of P-type connection regions 24 and a source region 23 that are disposed on a same layer. Each P-type connection region 24 corresponds to a location of one to-be-formed contact hole, and an orthographic projection of the P-type connection region 24 on the semiconductor substrate 10 falls within a range of an orthographic projection of the corresponding contact hole on the semiconductor substrate 10. The source region 23 is configured to be in contact with a subsequently formed source. Generally, doping concentration of the source region 23 is large. For example, the doping concentration of the source region 23 may be greater than the doping concentration of the N-type semiconductor region 21, so that the source region 23 has good conductivity. The P-type connection region 24 is configured to connect the first P-type semiconductor region 22 to the subsequently formed source. Doping concentration of the P-type connection region 24 may be greater than doping concentration of the first P-type semiconductor region 22, so that the P-type connection region 24 has good conductivity. During specific implementation, an N-type impurity like nitrogen (N), phosphorus (P), or arsenic (As) may be injected, by using the ion injection process, into a region in which the source region 23 is to be formed, to form the source region 23; and a P-type impurity like boron (B), aluminum (Al), or gallium (Ga) is injected, by using the ion injection process, into a region in which the P-type connection region 24 is to be formed, to form the P-type connection region 24.

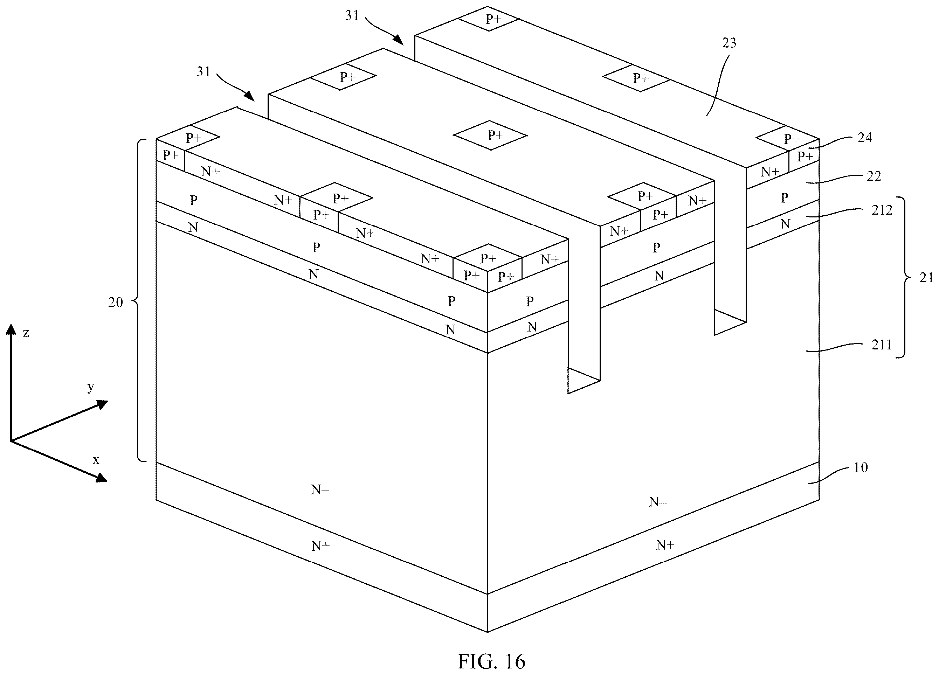

S92: Refer to FIG. 16 to FIG. 20. Etch the epitaxial layer 20 to form a first groove 31 and a second groove 32. In some embodiments of this application, the epitaxial layer 20 may include a plurality of first grooves 31 and a plurality of second grooves 32. The first grooves 31 extend in a first direction x and are arranged in a second direction y, the plurality of second grooves 32 extend in the second direction y and are arranged in the first direction x, the first grooves 31 and the second grooves 32 intersect with each other, the first direction x and the second direction y are two directions that are parallel to a plane on which the semiconductor substrate 10 is located and that intersect with each other. The first grooves 31 and the second grooves 32 extend to the inside of the epitaxial layer 20 in the third direction z from a surface of a side that is of the epitaxial layer 20 and that is away from the semiconductor substrate 10, and the third direction z is a direction perpendicular to the plane on which the semiconductor substrate 10 is located. A channel structure including the plurality of first grooves 31 and the plurality of second grooves 32 is manufactured, so that conductive channel density can be increased, and an on-resistance of the semiconductor device can be reduced.

In some embodiments of this application, step S92 may specifically include the following steps.

Refer to FIG. 16. The epitaxial layer 20 is etched to form the plurality of first grooves 31 that extend in the first direction x and that are arranged in the second direction y. For example, a mask consistent with a pattern of the first grooves 31 may be formed on the epitaxial layer, a region in which the first grooves 31 do not need to be formed may be covered by the mask, and a region in which the first grooves 31 need to be formed is exposed. Then, the region that is of the epitaxial layer 20 and that is not covered by the mask is etched by using an etching process, until the N-type semiconductor region 21 of the epitaxial layer 20 is etched, to obtain the plurality of first grooves 31.

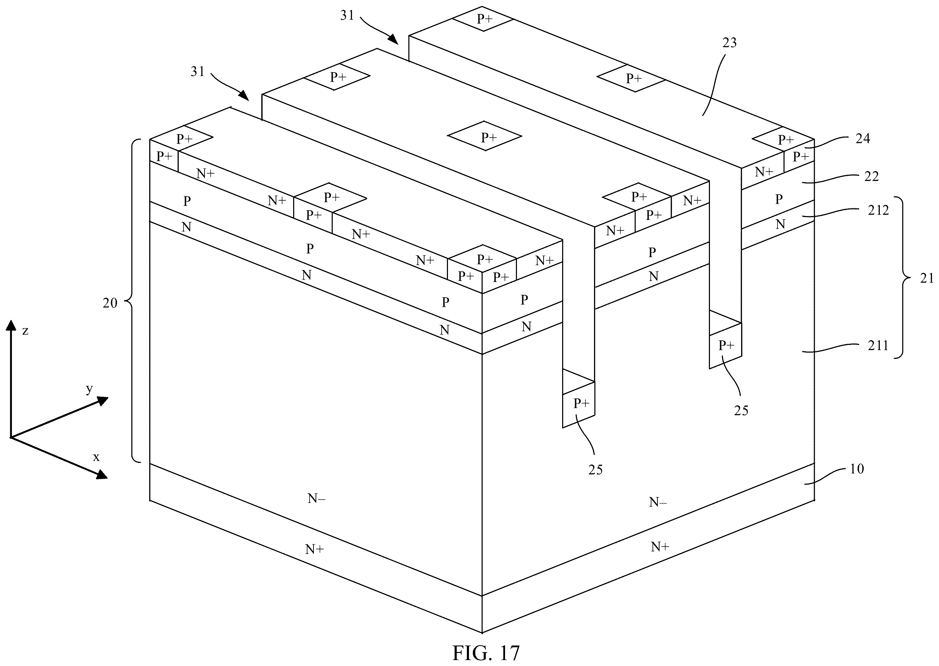

Refer to FIG. 17. Ions are injected into the bottom of the first groove 31 by using the ion injection process, to form a second P-type semiconductor region 25 on a side that is of the first groove 31 and that is close to the semiconductor substrate 10. The second P-type semiconductor region 25 may be electrically connected to the source 70. When the semiconductor device operates, a voltage is loaded to the source 70, and the voltage loaded to the source 70 is input to the second P-type semiconductor region 25, so that the second P-type semiconductor region 25 also has the corresponding voltage. This can effectively shield an electric field of a gate dielectric at the bottom of the groove, thereby improving operating robustness of the semiconductor device.

During specific implementation, a P-type impurity like boron (B), aluminum (Al), or gallium (Ga) may be injected into the bottom of the first groove 31, to obtain the second P-type semiconductor region 25. To make the second P-type semiconductor region 25 have good conductivity, doping concentration of the second P-type semiconductor region 25 may be large. For example, the doping concentration of the second P-type semiconductor region 25 may be greater than the doping concentration of the first P-type semiconductor region 22. For example, a thickness of the second P-type semiconductor region 25 in the third direction z may be less than 1 µm. For example, the thickness of the second P-type semiconductor region 25 in the third direction z may be 0.3 µm to 0.8 µm. Certainly, a thickness of the second P-type semiconductor region 25 in the third direction z may alternatively be greater than 1 µm. This is not limited herein.

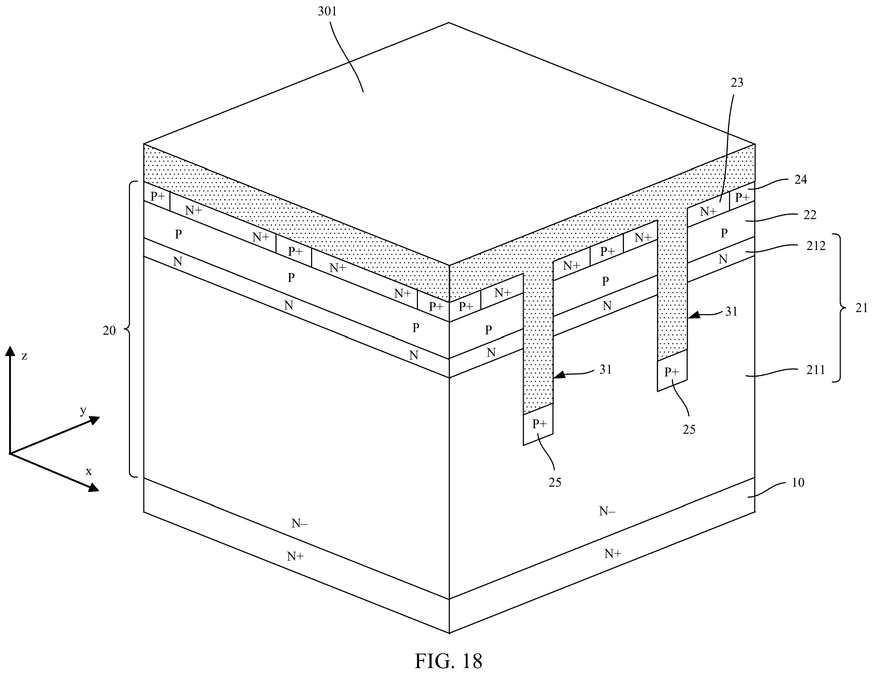

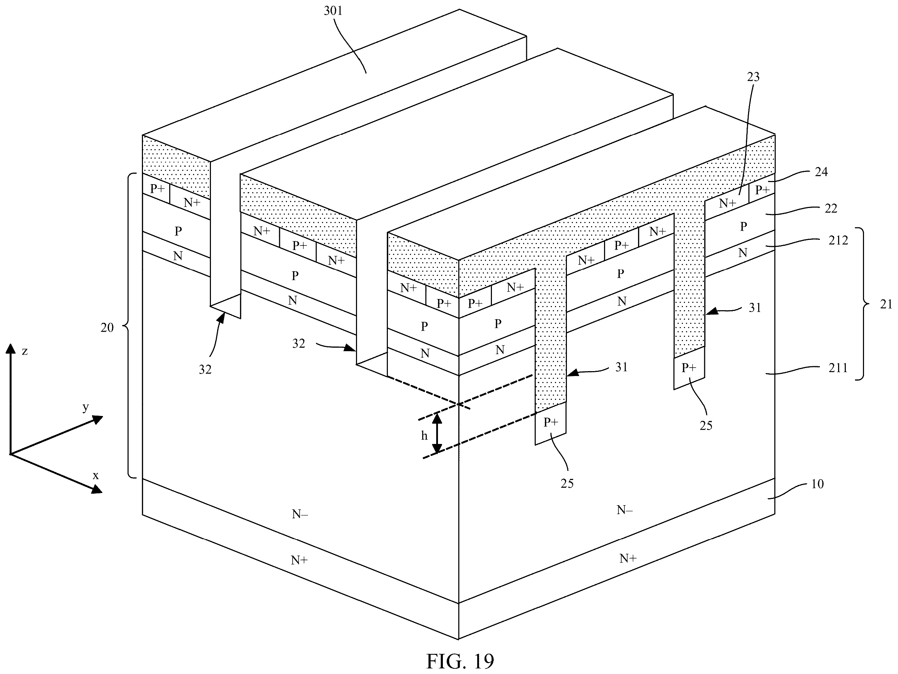

Refer to FIG. 18. A first dielectric layer 301 that fills each first groove 31 and that covers the surface of the epitaxial layer 20 is deposited. Refer to FIG. 19. The first dielectric layer 301 is patterned, so that a pattern of the first dielectric layer 301 is consistent with a pattern of the plurality of to-be-formed second grooves. For example, a photoresist layer may be formed on a surface of the first dielectric layer 301, and the photoresist layer is photoetched by using a mask having the pattern of the plurality of to-be-formed second grooves as a shield, to transfer the pattern on the mask to the photoresist layer. Then, the first dielectric layer 301 is etched by using the photoresist layer as a shield, to transfer the pattern of the plurality of second grooves to the first dielectric layer 301, where the first dielectric layer 301 may cover a region in which the second grooves 32 do not need to be formed, and expose a region in which the second grooves 32 need to be formed.

Still refer to FIG. 19. The epitaxial layer 20 is etched by using the first dielectric layer 301 as a mask, to form the plurality of second grooves 32 that extend in the second direction y and that are arranged in the first direction x. Because the first dielectric layer 301 may cover the region in which the second grooves 32 do not need to be formed, and expose the region in which the second grooves 32 need to be formed, the region that is of the epitaxial layer 20 and that is not covered by the first dielectric layer 301 is etched until the N-type semiconductor region 21 of the epitaxial layer 20 is etched, to obtain the plurality of second grooves 32.

In this embodiment of this application, a depth of each first groove 31 may be greater than a depth of each second groove 32. For example, in FIG. 19, a difference between the depth of the first groove 31 and the depth of the second groove 32 may be h. Therefore, a thickness of a sequentially formed first gate dielectric in the third direction z is greater than a thickness of a second gate dielectric in the third direction z.

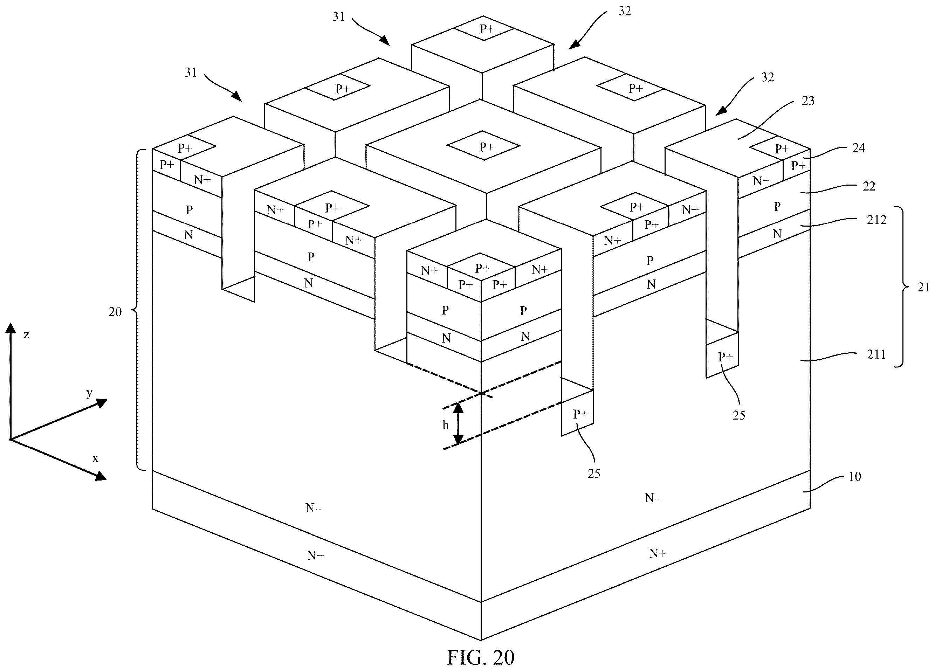

The first dielectric layer is removed to obtain a structure shown in FIG. 20.

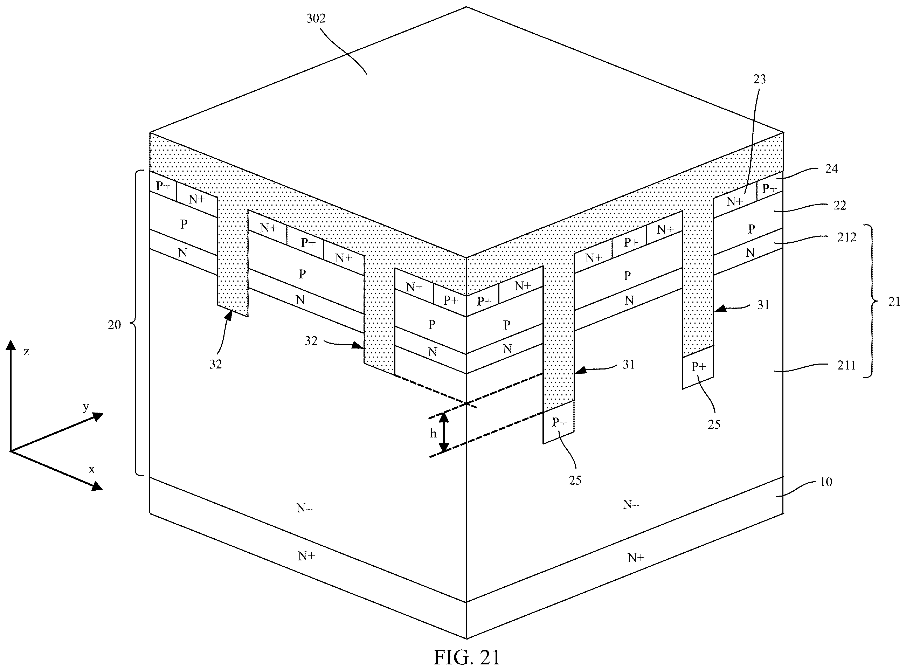

S93: Refer to FIG. 21 to FIG. 23. Form a first gate 41 and a first gate dielectric 51 in each first groove 31, and form a second gate 42 and a second gate dielectric 52 in each second groove 32. Therefore, the first gate 41 is filled into the first groove 31 separated by the first gate dielectric 51, and the second gate 42 is filled into the second groove 32 separated by the second gate dielectric 52, so that the first gate 41 and the second gate 42 are embedded inside the epitaxial layer 20.

In a possible implementation, step S93 may specifically include the following steps.

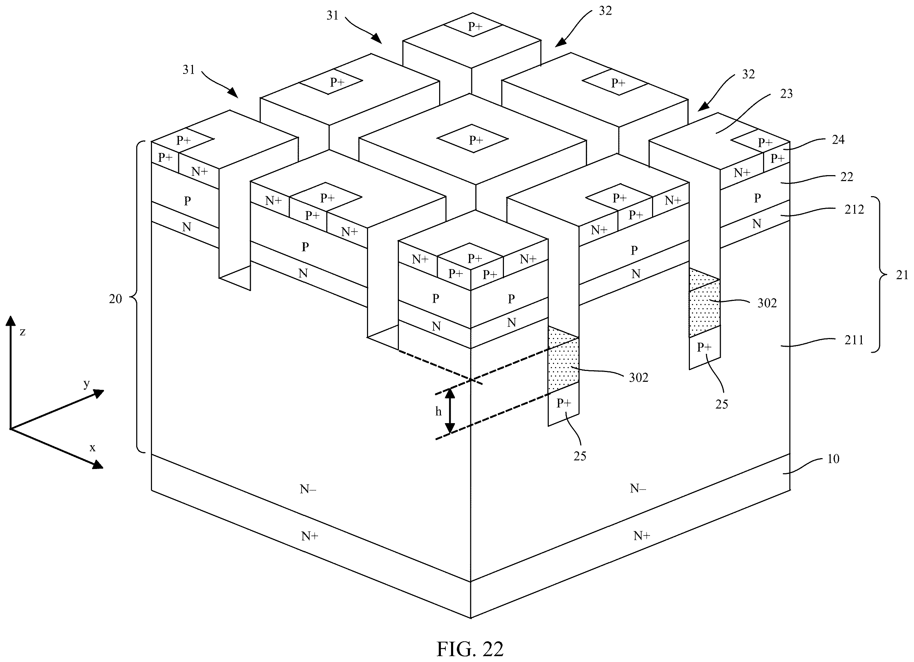

Refer to FIG. 21. A second dielectric layer 302 that fills each first groove 31 and each second groove 32 and that covers the surface of the epitaxial layer 20 is deposited. Refer to FIG. 22. The second dielectric layer 302 is etched until a bottom surface of each second groove 32 is exposed, and a part of the second dielectric layer 302 is left at the bottom of each first groove 31, where the part of the second dielectric layer 302 left at the bottom of the first groove 31 may be used as a part of the first gate dielectric. In this embodiment of this application, in a back-etching manner, the part of the first gate dielectric may be first formed at the bottom of the first groove 31. In this way, the remaining first gate dielectric and the second gate dielectric may be subsequently manufactured by using a same process step, or the first gate and the second gate may be manufactured by using a same process step.

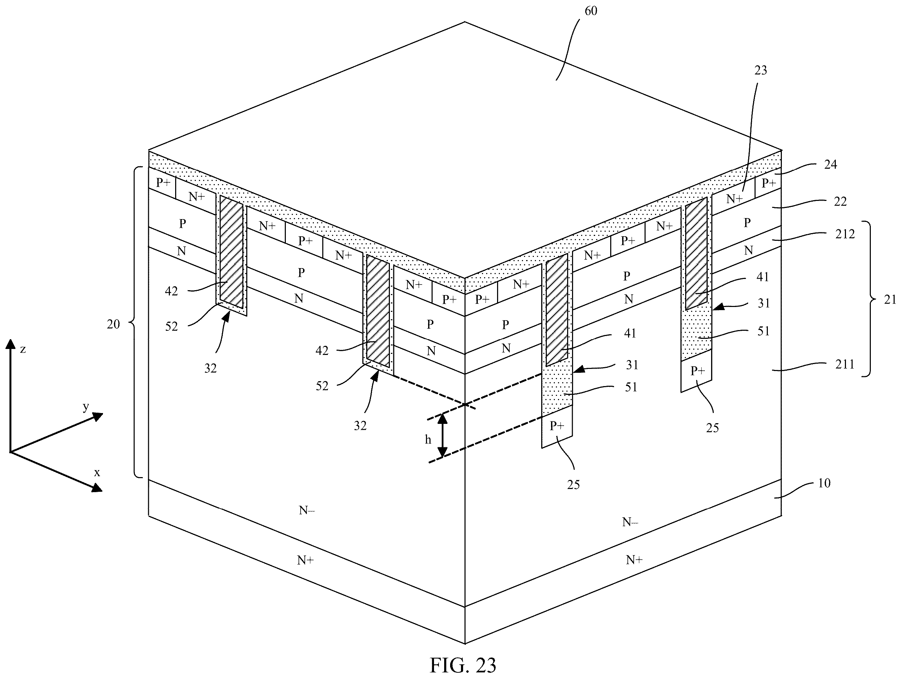

Refer to FIG. 23. The first gate dielectric 51 is formed on a side wall of each first groove 31, and the second gate dielectric 52 is formed on a side wall of each second groove 32. For example, the first gate dielectric 51 (or the second gate dielectric 52) may be formed on the side wall of the first groove 31 (or the second groove 32) by using a deposition process or an oxidation process.

A gate layer (not shown in the figure) that fills each first groove 31 and each second groove 32 and that covers the surface of the epitaxial layer 20 is deposited, where the gate layer may be made of a polycrystalline silicon material or a metal material. Then, the gate layer is etched until the surface of the epitaxial layer 20 is exposed, to form the first gate 41 in each first groove 31 and form the second gate 42 in each second groove 32. The first gate 41 and the second gate 42 are manufactured in a back-etching manner, so that the grooves can be accurately filled with the gates, to avoid insufficient filling or excessive filling.

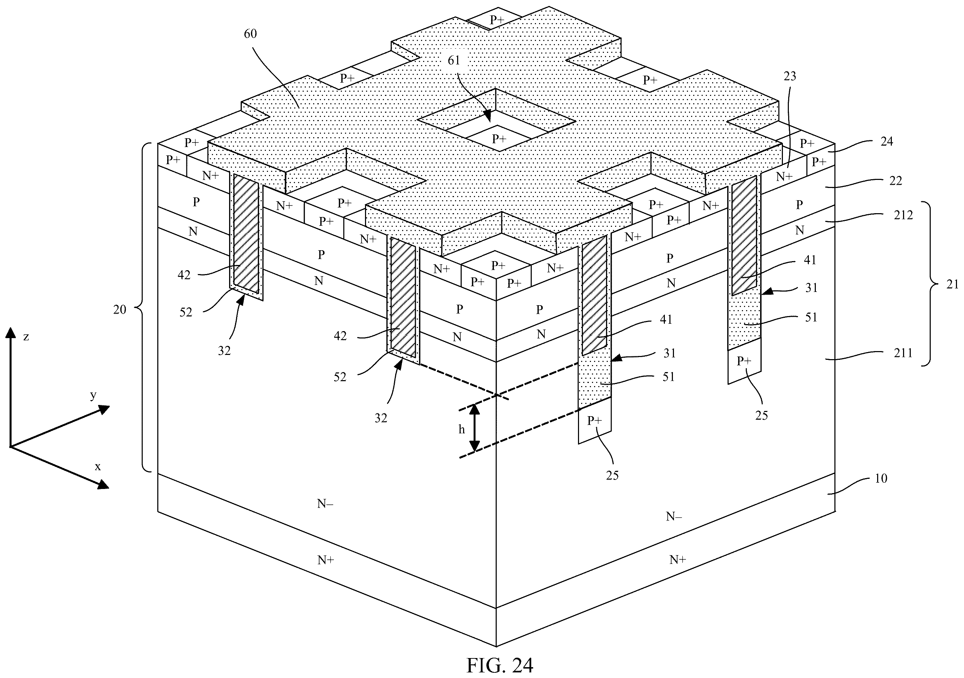

S94: Refer to FIG. 23. Form an interlayer dielectric layer 60 on the first gate 41 and the second gate 42, and with reference to FIG. 24, and pattern the interlayer dielectric layer 60, to form a plurality of contact holes 61 in the interlayer dielectric layer 60. Orthographic projections of the contact holes 61 on the semiconductor substrate 10 do not overlap orthographic projections of the first gate 41 and the second gate 42 on the semiconductor substrate 10. The plurality of contact holes 61 in the interlayer dielectric layer 60 may expose some regions of the epitaxial layer 20, so that the subsequently formed source can be in contact with the epitaxial layer 20 through the contact holes 61. The orthographic projections of the contact holes 61 on the semiconductor substrate 10 do not overlap the orthographic projections of the first gate 41 and the second gate 42 on the semiconductor substrate 10. This can prevent the source 70 from being in contact with the first gate 41 and the second gate 42.

For example, the interlayer dielectric layer 60 may be made of a dielectric material like silicon dioxide (SiO2), silicon oxynitride (SiNO), silicon oxycarbide (SiCO), or silicon nitride (SiNx).

S95: Form the source 70 on the interlayer dielectric layer 60, enable the source 70 to be in contact with the epitaxial layer 20 through the contact holes 61, and form a drain 80 on a side that is of the semiconductor substrate 10 and that is away from the epitaxial layer 20, to obtain the semiconductor device shown in FIG. 3. For example, the source 70 and the drain 80 may be made of a metal material like W, Al, Ti, Cu, Mo, or Pt.

The manufacturing method of the semiconductor device in this embodiment of this application is described in detail above by using the semiconductor device shown in FIG. 3 as an example. Compared with the semiconductor device shown in FIG. 3, in the semiconductor devices shown in FIG. 9 and FIG. 10, the epitaxial layer 20 may further include a third P-type semiconductor region 26. The third P-type semiconductor region 26 is located on a side that is of the second groove 32 and that is close to the semiconductor substrate 10, and the third P-type semiconductor region 26 is electrically connected to the source 70.

Different from the manufacturing method of the semiconductor device shown in FIG. 3, manufacturing methods of the semiconductor devices shown in FIG. 9 and FIG. 10 may be adjusted as follows:

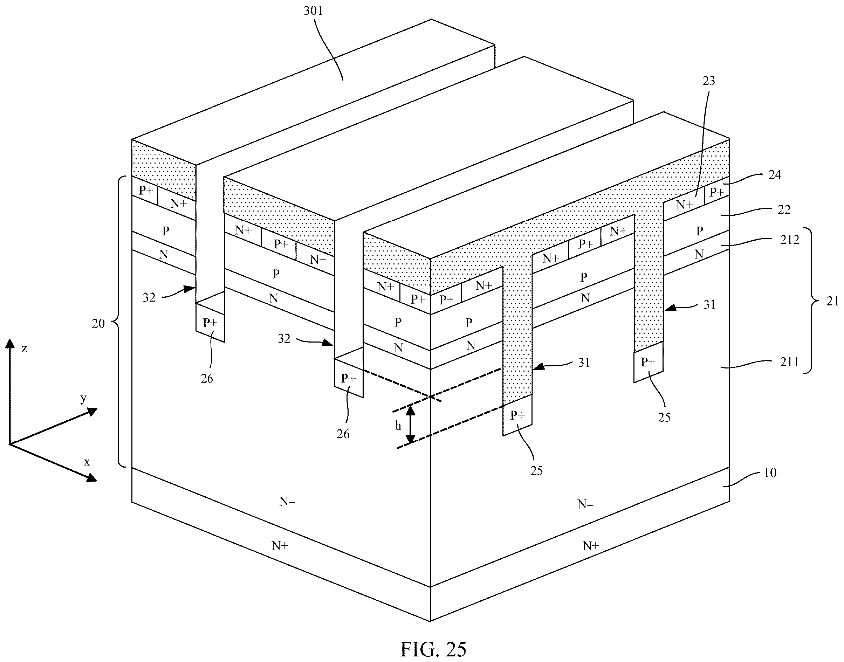

FIG. 25 is a diagram of a structure corresponding to a step of manufacturing the third P-type semiconductor region. Refer to FIG. 25. In step S92, after the epitaxial layer is etched by using the first dielectric layer as the mask, to form the plurality of second grooves that extend in the second direction and that are arranged in the first direction, and before the first dielectric layer is removed, the method may further include the following step.

Ions are injected into the bottom of the second groove 32 by using an ion injection process, to form the third P-type semiconductor region 26 on the side that is of the second groove 32 and that is close to the semiconductor substrate 10.

For example, a P-type impurity like boron (B), aluminum (Al), or gallium (Ga) may be injected into the bottom of the second groove 32, to form the third P-type semiconductor region 26. During specific implementation, to make the third P-type semiconductor region 26 have good conductivity, doping concentration of the third P-type semiconductor region 26 may be set to be large. For example, the doping concentration of the third P-type semiconductor region 26 may be greater than the doping concentration of the first P-type semiconductor region 22.

In a possible implementation, a thickness of the third P-type semiconductor region 26 in the third direction z may be less than 1 µm, and thicknesses of the second P-type semiconductor region 25 and the third P-type semiconductor region 26 in the third direction z may be approximately equal within a process error range, so that the second P-type semiconductor region 25 and the third P-type semiconductor region 26 may be manufactured together by using a same manufacturing process. This can reduce process steps, and reduce manufacturing costs.

In another possible implementation, a thickness of the third P-type semiconductor region 26 in the third direction z may alternatively be greater than 1 µm, and the thickness of the third P-type semiconductor region 26 in the third direction z may be greater than the thickness of the second P-type semiconductor region 25 in the third direction z. In a manufacturing procedure, the second P-type semiconductor region 25 and the third P-type semiconductor region 26 may be separately manufactured by using different process steps.

Other steps in the manufacturing methods of the semiconductor devices shown in FIG. 9 and FIG. 10 may be performed with reference to the manufacturing method of the semiconductor device shown in FIG. 3. Repeated parts are not described again.

In addition, manufacturing methods of the semiconductor devices shown in FIG. 8, FIG. 11, and FIG. 12 may also be performed with reference to the foregoing manufacturing methods, or may be correspondingly adjusted according to the foregoing manufacturing methods. Examples are not described one by one herein.

Based on a same technical idea, an embodiment of this application further provides a power conversion circuit. The power conversion circuit may be an alternating current-direct current conversion circuit and/or a direct current-direct current conversion circuit. The power conversion circuit may include a circuit board and one or more of the foregoing semiconductor devices, and the semiconductor device is connected to the circuit board. Because the foregoing semiconductor device has good performance, the power conversion circuit including the foregoing semiconductor device also has good performance.

A problem-resolving principle of the power conversion circuit is similar to a problem-resolving principle of the foregoing semiconductor device. Therefore, for technical effect of the power conversion circuit, refer to the technical effect of the foregoing semiconductor device. Repeated parts are not described again.

Based on a same technical idea, an embodiment of this application further provides a vehicle. The vehicle includes the foregoing power conversion circuit provided in embodiments of this application. The power conversion circuit is configured to convert an alternating current and/or a direct current and then output a direct current. Because the power conversion circuit has good performance, the vehicle including the power conversion circuit also has good circuit performance.

A problem-resolving principle of the vehicle is similar to the problem-resolving principle of the foregoing power conversion circuit. Therefore, for technical effect of the vehicle, refer to the technical effect of the foregoing power conversion circuit. Repeated parts are not described again.

Although some preferred embodiments of this application have been described, persons skilled in the art can make changes and modifications to these embodiments once they learn of a basic inventive concept. Therefore, the appended claims are intended to be construed as to cover the preferred embodiments and all changes and modifications falling within the scope of this application.

Clearly, persons skilled in the art can make various modifications and variations to embodiments of this application without departing from the spirit and scope of embodiments of this application. In this case, this application is intended to cover these modifications and variations of embodiments of this application provided that they fall within the scope of protection defined by the following claims and their equivalent technologies.

## Claims

1. A semiconductor device, comprising:
an N-type semiconductor substrate;
an epitaxial layer, disposed on the semiconductor substrate; and
a first gate and a second gate that are connected to each other, wherein the first gate extends in a first direction, the second gate extends in a second direction, and the first direction and the second direction are two directions that are parallel to a plane on which the semiconductor substrate is located and that intersect with each other; and
the first gate and the second gate are respectively located in different grooves in the epitaxial layer; a first gate dielectric is filled between the first gate and the groove, and the first gate is isolated from the groove through the first gate dielectric; a second gate dielectric is filled between the second gate and the groove, and the second gate is isolated from the groove through the second gate dielectric; and in a direction perpendicular to the plane on which the semiconductor substrate is located, a thickness of the first gate dielectric is greater than a thickness of the second gate dielectric.

2. The semiconductor device according to claim 1, wherein a plurality of first grooves and a plurality of second grooves are disposed in the epitaxial layer; the plurality of first grooves extend in the first direction and are arranged in the second direction; the plurality of second grooves extend in the second direction and are arranged in the first direction; the plurality of first grooves intersect with the plurality of second grooves; and the plurality of first grooves and the plurality of second grooves extend to the inside of the epitaxial layer in a third direction from a surface of a side that is of the epitaxial layer and that is away from the semiconductor substrate, wherein the third direction is the direction perpendicular to the plane on which the semiconductor substrate is located; and
the first gate is located in the first groove, and the second gate is located in the second groove.

3. The semiconductor device according to claim 2, wherein a depth of each first groove is greater than a depth of each second groove; and
a thickness of each first gate in the third direction is consistent with a thickness of each second gate in the third direction.

4. The semiconductor device according to claim 2, wherein the epitaxial layer comprises an N-type semiconductor region, a first P-type semiconductor region, and a second P-type semiconductor region;
the first P-type semiconductor region is located on a side that is of the N-type semiconductor region and that is away from the semiconductor substrate;
the plurality of first grooves and the plurality of second grooves penetrate the first P-type semiconductor region in the third direction, and extend into the N-type semiconductor region; and
the second P-type semiconductor region is located on a side that is of the first groove and that is close to the semiconductor substrate, and the second P-type semiconductor region is electrically connected to the source.

5. The semiconductor device according to claim 4, wherein the N-type semiconductor region comprises a first N-type semiconductor region and a second N-type semiconductor region;
the second N-type semiconductor region is located between the first N-type semiconductor region and the first P-type semiconductor region;
doping concentration of the second N-type semiconductor region is greater than doping concentration of the first N-type semiconductor region;
the plurality of first grooves and the plurality of second grooves penetrate the second N-type semiconductor region in the third direction, and extend into the first N-type semiconductor region; and
the second P-type semiconductor region is located in the first N-type semiconductor region.

6. The semiconductor device according to claim 4, wherein the N-type semiconductor region comprises a first N-type semiconductor region, a second N-type semiconductor region, and a third N-type semiconductor region;
the second N-type semiconductor region is located on a side that is of the first N-type semiconductor region and that is away from the semiconductor substrate, and the third N-type semiconductor region is located between the first N-type semiconductor region and the second N-type semiconductor region;
doping concentration of the second N-type semiconductor region is greater than doping concentration of the first N-type semiconductor region, and doping concentration of the third N-type semiconductor region is greater than the doping concentration of the first N-type semiconductor region;
the plurality of first grooves and the plurality of second grooves penetrate the second N-type semiconductor region in the third direction, and extend into the third N-type semiconductor region; and
the second P-type semiconductor region is located in the third N-type semiconductor region.

7. The semiconductor device according to claim 4, wherein the epitaxial layer further comprises a third P-type semiconductor region; and
the third P-type semiconductor region is located on a side that is of the second groove and that is close to the semiconductor substrate, and the third P-type semiconductor region is electrically connected to the source.

8. The semiconductor device according to claim 7, wherein the N-type semiconductor region comprises a first N-type semiconductor region and a second N-type semiconductor region;
the second N-type semiconductor region is located between the first N-type semiconductor region and the first P-type semiconductor region;
doping concentration of the second N-type semiconductor region is greater than doping concentration of the first N-type semiconductor region;
the plurality of first grooves and the plurality of second grooves penetrate the second N-type semiconductor region in the third direction, and extend into the first N-type semiconductor region; and
the second P-type semiconductor region and the third P-type semiconductor region are located in the first N-type semiconductor region.

9. The semiconductor device according to claim 7, wherein the N-type semiconductor region comprises a first N-type semiconductor region, a second N-type semiconductor region, and a third N-type semiconductor region;
the second N-type semiconductor region is located on a side that is of the first N-type semiconductor region and that is away from the semiconductor substrate, and the third N-type semiconductor region is located between the first N-type semiconductor region and the third N-type semiconductor region;
doping concentration of the second N-type semiconductor region is greater than doping concentration of the first N-type semiconductor region, and doping concentration of the third N-type semiconductor region is greater than the doping concentration of the first N-type semiconductor region;
the plurality of first grooves and the plurality of second grooves penetrate the second N-type semiconductor region in the third direction, and extend into the third N-type semiconductor region; and
the second P-type semiconductor region and the third P-type semiconductor region are located in the third N-type semiconductor region.

10. The semiconductor device according to any one of claims 4 to 9, the semiconductor device further comprises:
an interlayer dielectric layer, wherein the interlayer dielectric layer covers a surface of a side that is of the first gate and the second gate and that is away from the semiconductor substrate, a plurality of contact holes are disposed in the interlayer dielectric layer, and orthographic projections of the plurality of contact holes on the semiconductor substrate do not overlap orthographic projections of the first gate and the second gate on the semiconductor substrate;
the source, wherein the source is disposed on a side that is of the interlayer dielectric layer and that is away from the semiconductor substrate, and the source is in contact with the epitaxial layer through the plurality of contact holes; and
a drain, wherein the drain is located on a side that is of the semiconductor substrate and that is away from the epitaxial layer.

11. The semiconductor device according to claim 10, wherein the epitaxial layer further comprises a plurality of P-type connection regions and a source region that are disposed on a same layer;
each P-type connection region corresponds to a location of one contact hole, an orthographic projection of the P-type connection region on the semiconductor substrate falls within a range of the orthographic projection of the corresponding contact hole on the semiconductor substrate, and the P-type connection region connects the first P-type semiconductor region to the source; and
the source region is a region other than the plurality of first grooves, the plurality of second grooves, and the plurality of P-type connection regions on the layer on which the source region is located.

12. The semiconductor device according to claim 11, wherein a part of the source region is covered by the interlayer dielectric layer, and another part is electrically connected to the source.

13. A manufacturing method of the semiconductor device according to any one of claims 1 to 12, comprising:
growing an epitaxial layer on an N-type semiconductor substrate;
etching the epitaxial layer to form a first groove and a second groove; and
forming a first gate and a first gate dielectric in the first groove, and forming a second gate and a second gate dielectric in the second groove, wherein in a direction perpendicular to a plane on which the semiconductor substrate is located, a thickness of the first gate dielectric is greater than a thickness of the second gate dielectric.

14. The manufacturing method according to claim 13, wherein the growing the epitaxial layer on the N-type semiconductor substrate comprises:
forming an N-type semiconductor region on the semiconductor substrate by using an epitaxial process, and injecting ions into the N-type semiconductor region by using an ion injection process, to form a first P-type semiconductor region; and
injecting ions into a surface of the epitaxial layer by using the ion injection process, to form a plurality of P-type connection regions and a source region that are disposed on a same layer, wherein each P-type connection region corresponds to a location of one to-be-formed contact hole, and an orthographic projection of the P-type connection region on the semiconductor substrate falls within a range of an orthographic projection of the corresponding contact hole on the semiconductor substrate.

15. The manufacturing method according to claim 13 or 14, wherein the etching the epitaxial layer to form the first groove and the second groove comprises:
etching the epitaxial layer to form the plurality of first grooves that extend in a first direction and that are arranged in a second direction, wherein the first direction and the second direction are two directions that are parallel to the plane on which the semiconductor substrate is located and that intersect with each other;
depositing a first dielectric layer that fills each first groove and that covers the surface of the epitaxial layer, and patterning the first dielectric layer, so that a pattern of the first dielectric layer is consistent with a pattern of the plurality of to-be-formed second grooves; and
etching the epitaxial layer by using the first dielectric layer as a mask, to form the plurality of second grooves that extend in the second direction and that are arranged in the first direction; and
removing the first dielectric layer.

16. The manufacturing method according to claim 15, wherein after the etching the epitaxial layer to form the plurality of first grooves that extend in the first direction and that are arranged in the second direction, and before the depositing the first dielectric layer that fills each first groove and that covers the surface of the epitaxial layer, the method further comprises:
injecting ions into a bottom of the first groove by using the ion injection process, to form a second P-type semiconductor region on a side that is of the first groove and that is close to the semiconductor substrate.

17. The manufacturing method according to claim 15, wherein after the etching the epitaxial layer by using the first dielectric layer as the mask, to form the plurality of second grooves that extend in the second direction and that are arranged in the first direction, and before the removing the first dielectric layer, the method further comprises:
injecting ions into a bottom of the second groove by using the ion injection process, to form a third P-type semiconductor region on a side that is of the second groove and that is close to the semiconductor substrate.

18. The manufacturing method according to any one of claims 13 to 17, wherein the forming the first gate and the first gate dielectric in the first groove, and the forming the second gate and the second gate dielectric in the second groove comprise:
depositing a second dielectric layer that fills each first groove and each second groove and that covers the surface of the epitaxial layer;
etching the second dielectric layer until a bottom surface of each second groove is exposed, and leaving a part of the second dielectric layer at the bottom of each first groove;
forming the first gate dielectric on a side wall of each first groove, and forming the second gate dielectric on a side wall of each second groove;
depositing a gate layer that fills each first groove and each second groove and that covers the surface of the epitaxial layer; and
etching the gate layer until the surface of the epitaxial layer is exposed, to form the first gate in each first groove and form the second gate in each second groove.

19. The manufacturing method according to any one of claims 13 to 18, wherein the manufacturing method further comprises:
forming an interlayer dielectric layer on the first gate and the second gate, and patterning the interlayer dielectric layer, to form a plurality of contact holes in the interlayer dielectric layer, wherein orthographic projections of the plurality of contact holes on the semiconductor substrate do not overlap orthographic projections of the first gate and the second gate on the semiconductor substrate; and
forming a source on the interlayer dielectric layer, and enabling the source to be in contact with the epitaxial layer through the plurality of contact holes; and forming a drain on a side that is of the semiconductor substrate and that is away from the epitaxial layer.

20. A power conversion circuit, comprising a circuit board and one or more semiconductor devices according to any one of claims 1 to 12, wherein the semiconductor device is connected to the circuit board.

21. A vehicle, comprising the power conversion circuit according to claim 20, wherein the power conversion circuit is configured to convert an alternating current and/or a direct current and then output a direct current.
